(19) Europäisches Patentamt
European Patent Office
Office européen des brevets

(11) EP 3 004 227 B1

(12) **EUROPEAN PATENT SPECIFICATION**

(45) Date of publication and mention of the grant of the patent:
**24.07.2019 Bulletin 2019/30**

(21) Application number: **14738611.4**

(22) Date of filing: **04.06.2014**

(51) Int Cl.:
***C08K 3/00*** *(2018.01)* ***H05K 3/10*** *(2006.01)*
***C08K 3/22*** *(2006.01)*

(86) International application number:
**PCT/IB2014/061956**

(87) International publication number:
**WO 2014/195889 (11.12.2014 Gazette 2014/50)**

(54) **THERMALLY CONDUCTIVE POLYMER COMPOSITIONS WITH LASER DIRECT STRUCTURING FUNCTION**

THERMISCH LEITFÄHIGE POLYMERZUSAMMENSETZUNGEN MIT DIREKTLASERSTRUKTURIERUNGSFUNKTION

COMPOSITIONS POLYMÈRES THERMOCONDUCTRICES AYANT UNE FONCTION DE STRUCTURATION DIRECTE AU LASER

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.06.2013 US 201361830941 P**
**30.12.2013 US 201361922064 P**

(43) Date of publication of application:
**13.04.2016 Bulletin 2016/15**

(73) Proprietor: **SABIC Global Technologies B.V.**
**4612 PX Bergen op Zoom (NL)**

(72) Inventors:
- **WU, Tong**
  **Shanghai 201203**
  **China (CN)**
- **GUO, Mingcheng**
  **Shanghai 201203**
  **China (CN)**
- **WANG, Jiwen**
  **Shanghai 201203**
  **China (CN)**
- **ZHANG, Yaqin**
  **Shanghai 201203**
  **China (CN)**
- **AN, Yuxian**
  **Shanghai 201203**
  **China (CN)**

(74) Representative: **Agasse, Stéphane et al**
**Cabinet GERMAIN & MAUREAU**
**B.P. 6153**
**69466 Lyon Cedex 06 (FR)**

(56) References cited:
**WO-A1-2012/126831**
**WO-A1-2014/096153**
**WO-A1-2014/115092**
**WO-A2-2013/012685**
**US-A1- 2012 217 434**
**US-A1- 2012 279 764**

- **DATABASE WPI Week 201377 Thomson Scientific, London, GB; AN 2013-E37825 XP002728674, -& CN 102 796 372 A (DONGGUAN SINO PLAST IND LTD) 28 November 2012 (2012-11-28)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 004 227 B1

## Description

### BACKGROUND

Decreasing the dimensions and weight of components as well as increasing performance in portable electronics is a key market demand. Laser direct structuring technology is increasingly used to satisfy these needs and allows production of materials with ultra-fine precision, high reliability, improved miniaturization, and great flexibility when changing and improving functionality of the target portable electronic product. However, the reduction in size of electronic devices results in greater heat retention which can degrade device performance. Thermally conductive materials are typically used to dissipate heat in many devices such as, for example, light emitting diode ("LED") lamps, e-motors, circuits, processors and coil bobbins. However, there remains a need for suitable polymer compositions that have improved thermal conductivity, while retaining required properties of laser direct structure activation, strength, and flow.

Accordingly, there is a growing need for novel thermally conductive polymer compositions comprising laser direct structuring additives which provide superior heat dissipation, strength, and flow.

### SUMMARY

The present disclosure satisfies these and other needs by providing ultrahigh performance thermoplastic polymer compositions which integrated thermally conductivity performance with laser direct structuring function, thus greatly expanding the scope of laser direct structuring technology.

In one embodiment, the present disclosure pertains to blended thermoplastic compositions comprising: from 50 wt% to 95 wt% of a polyamide polymer; wherein the polyamide polymer comprises a first polyamide polymer and a second polyamide polymer; wherein the first polyamide polymer comprises polyamide 6 and polyamide 6,6; and wherein the second polyamide polymer is selected from polyamide 10,10; polyamide 10,12; or polyamide 12,12; or a combination thereof; from 4 wt% to 49.95 wt% of a thermally conductive filler wherein the thermally conductive filler is a high thermally conductive filler having a thermal conductivity greater than or equal to 50 W/mK, and comprises AlN, $Al_4C_3$, $Al_2O_3$, BN, AlON, $MgSiN_2$, SiC, $Si_3N_4$, graphite, expanded graphite, graphene, or carbon fiber, or combinations thereof; and from 0.05 wt% to 20 wt% of a laser direct structuring additive; wherein the combined weight percent value of all components does not exceed 100 wt%; wherein all weight percent values are based on the total weight of the composition ; wherein a molded sample of the blended thermoplastic composition has a through plane thermal conductivity of at least 0.40 W/mK when determined in accordance with ASTM E1461 according to the description, and wherein a molded sample of the blended thermoplastic composition exhibits a plating index value of at least 0.4 when determined in accordance with ATSM B568 according to the description.

In various further embodiments, the disclosure relates to articles comprising the disclosed compositions.

In a further embodiment, the disclosure relates to a method of improving the thermal conductivity properties of blended thermoplastic composition according to claim 12.

### DETAILED DESCRIPTION

The present disclosure can be understood more readily by reference to the following detailed description of the disclosure and the Examples included therein.

References in the specification and concluding claims to parts by weight (pbw) of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

As used herein the terms "weight percent," "wt%," and "wt.%," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation are equal to 100.

Compounds are described using standard nomenclature. For example, any position not substituted by any indicated group is understood to have its valence filled by a bond as indicated, or a hydrogen atom. A dash ("-") that is not between two letters or symbols is used to indicate a point of attachment for a substituent. For example, -CHO is attached through carbon of the carbonyl group. Unless defined otherwise, technical and scientific terms used herein have the same meaning as is commonly understood by one of skill in the art to which this disclosure belongs.

The term "alkyl group" as used herein is a branched or unbranched saturated hydrocarbon group of 1 to 24 carbon atoms, such as methyl, ethyl, n propyl, isopropyl, n butyl, isobutyl, t butyl, pentyl, hexyl, heptyl, octyl, decyl, tetradecyl, hexadecyl, eicosyl, tetracosyl and the like. A "lower alkyl" group is an alkyl group containing from one to six

carbon atoms.

The term "aryl group" as used herein is any carbon-based aromatic group including, but not limited to, benzene, naphthalene, etc. The term "aromatic" also includes "heteroaryl group," which is defined as an aromatic group that has at least one heteroatom incorporated within the ring of the aromatic group. Examples of heteroatoms include, but are not limited to, nitrogen, oxygen, sulfur, and phosphorus. The aryl group can be substituted or unsubstituted. The aryl group can be substituted with one or more groups including, but not limited to, alkyl, alkynyl, alkenyl, aryl, halide, nitro, amino, ester, ketone, aldehyde, hydroxy, carboxylic acid, or alkoxy.

The term "aralkyl" as used herein is an aryl group having an alkyl, alkynyl, or alkenyl group as defined above attached to the aromatic group. An example of an aralkyl group is a benzyl group.

The term "carbonate group" as used herein is represented by the formula OC(O)OR, where R can be hydrogen, an alkyl, alkenyl, alkynyl, aryl, aralkyl, cycloalkyl, halogenated alkyl, or heterocycloalkyl group described above.

The term "organic residue" defines a carbon containing residue, i.e., a residue comprising at least one carbon atom, and includes but is not limited to the carbon-containing groups, residues, or radicals defined hereinabove. Organic residues can contain various heteroatoms, or be bonded to another molecule through a heteroatom, including oxygen, nitrogen, sulfur, phosphorus, or the like. Examples of organic residues include but are not limited alkyl or substituted alkyls, alkoxy or substituted alkoxy, mono or di-substituted amino, amide groups, etc. Organic residues can preferably comprise 1 to 18 carbon atoms, 1 to 15, carbon atoms, 1 to 12 carbon atoms, 1 to 8 carbon atoms, 1 to 6 carbon atoms, or 1 to 4 carbon atoms. In a further embodiment, an organic residue can comprise 2 to 18 carbon atoms, 2 to 15, carbon atoms, 2 to 12 carbon atoms, 2 to 8 carbon atoms, 2 to 4 carbon atoms, or 2 to 4 carbon atoms.

A very close synonym of the term "residue" is the term "radical," which as used in the specification and concluding claims, refers to a fragment, group, or substructure of a molecule described herein, regardless of how the molecule is prepared. For example, a 2,4-dihydroxyphenyl radical in a particular compound has the structure:

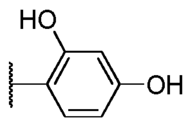

regardless of whether 2,4-dihydroxyphenyl is used to prepare the compound. In some embodiments the radical (for example an alkyl) can be further modified (i.e., substituted alkyl) by having bonded thereto one or more "substituent radicals." The number of atoms in a given radical is not critical to the present disclosure unless it is indicated to the contrary elsewhere herein.

"Organic radicals," as the term is defined and used herein, contain one or more carbon atoms. An organic radical can have, for example, 1 to 26 carbon atoms, 1 to 18 carbon atoms, 1 to 12 carbon atoms, 1 to 8 carbon atoms, 1 to 6 carbon atoms, or 1 to 4 carbon atoms. In a further embodiment, an organic radical can have 2 to 26 carbon atoms, 2 to 18 carbon atoms, 2 to 12 carbon atoms, 2 to 8 carbon atoms, 2 to 6 carbon atoms, or 2 to 4 carbon atoms. Organic radicals often have hydrogen bound to at least some of the carbon atoms of the organic radical. One example, of an organic radical that comprises no inorganic atoms is a 5, 6, 7, 8-tetrahydro-2-naphthyl radical. In some embodiments, an organic radical can contain 1 to 10 inorganic heteroatoms bound thereto or therein, including halogens, oxygen, sulfur, nitrogen, phosphorus, and the like. Examples of organic radicals include but are not limited to an alkyl, substituted alkyl, cycloalkyl, substituted cycloalkyl, monosubstituted amino, di-substituted amino, acyloxy, cyano, carboxy, carboalkoxy, alkylcarboxamide, substituted alkylcarboxamide, dialkylcarboxamide, substituted dialkylcarboxamide, alkylsulfonyl, alkylsulfinyl, thioalkyl, thiohaloalkyl, alkoxy, substituted alkoxy, haloalkyl, haloalkoxy, aryl, substituted aryl, heteroaryl, heterocyclic, or substituted heterocyclic radicals, wherein the terms are defined elsewhere herein. A few non-limiting examples of organic radicals that include heteroatoms include alkoxy radicals, trifluoromethoxy radicals, acetoxy radicals, dimethylamino radicals and the like.

As used herein, the terms "number average molecular weight" or "$M_n$" can be used interchangeably, and refer to the statistical average molecular weight of all the polymer chains in the sample and is defined by the formula:

$$M_n = \frac{\sum N_i M_i}{\sum N_i},$$

where $M_i$ is the molecular weight of a chain and $N_i$ is the number of chains of that molecular weight. $M_n$ can be determined for polymers, e.g., polycarbonate polymers, by methods well known to a person having ordinary skill in the art using molecular weight standards, e.g. polycarbonate standards or polystyrene standards, preferably certified or traceable molecular weight standards.

As used herein, the terms "weight average molecular weight" or "Mw" can be used interchangeably, and are

defined by the formula:

$$M_w = \frac{\sum N_i M_i^2}{\sum N_i M_i},$$

where $M_i$ is the molecular weight of a chain and $N_i$ is the number of chains of that molecular weight. Compared to $M_n$, $M_w$ takes into account the molecular weight of a given chain in determining contributions to the molecular weight average. Thus, the greater the molecular weight of a given chain, the more the chain contributes to the $M_w$. $M_w$ can be determined for polymers, e.g. polycarbonate polymers, by methods well known to a person having ordinary skill in the art using molecular weight standards, e.g. polycarbonate standards or polystyrene standards, preferably certified or traceable molecular weight standards.

As used herein, the terms "polydispersity index" or "PDI" can be used interchangeably, and are defined by the formula:

$$PDI = \frac{M_w}{M_n}.$$

The PDI has a value equal to or greater than 1, but as the polymer chains approach uniform chain length, the PDI approaches unity.

The terms "residues" and "structural units", used in reference to the constituents of the polymers, are synonymous throughout the specification.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions, and it is understood that there are a variety of structures that can perform the same function that are related to the disclosed structures, and that these structures will typically achieve the same result.

In various embodiments, the present disclosure pertains to blended thermoplastic compositions, wherein a molded sample of the blended thermoplastic composition has a through plane thermal conductivity of at least 0.45 W/mK when determined in accordance with ASTM E1461. In a further embodiment, a molded sample of the blended thermoplastic composition has a through plane thermal conductivity of at least 0.50 W/mK when determined in accordance with ASTM E1461. In a still further embodiment, a molded sample of the blended thermoplastic composition has a through plane thermal conductivity from 0.40 W/mK to 25 W/mK when determined in accordance with ASTM E1461. In a yet further embodiment, a molded sample of the blended thermoplastic composition has a through plane thermal conductivity from 0.45 W/mK to 23 W/mK when determined in accordance with ASTM E1461. In an even further embodiment, a molded sample of the blended thermoplastic composition has a through plane thermal conductivity from 0.50 W/mK to 20 W/mK when determined in accordance with ASTM E1461.

In various embodiments, the present disclosure pertains to blended thermoplastic compositions, wherein a molded sample of the blended thermoplastic composition exhibits a plating index value of at least 0.6. In a further embodiment, a molded sample of the blended thermoplastic composition exhibits a plating index value of at least 0.7. In a still further embodiment, a molded sample of the blended thermoplastic composition exhibits a plating index value from 0.5 to 1.5. In a yet further embodiment, a molded sample of the blended thermoplastic composition exhibits a plating index value from 0.6 to 1.2. In an even further embodiment, a molded sample of the blended thermoplastic composition exhibits a plating index value from 0.7 to 1.9.

In various embodiments, the compositions of the present disclosure further comprise an additive selected from coupling agents, antioxidants, mold release agents, UV absorbers, light stabilizers, heat stabilizers, lubricants, plasticizers, pigments, dyes, colorants, anti-static agents, nucleating agents, anti-drip agents, acid scavengers, and combinations of two or more of the foregoing. In a further embodiment, compositions of the present disclosure further comprise at least one additive selected from a flame retardant, a colorant, a primary anti-oxidant, and a secondary anti-oxidant.

The term polyamide as used herein is not intended to refer to only a specific polyamide or group of polyamides, but rather refers to any one of the class of compounds containing a repeating chain of amide groups. Polyamides, also known as polyamides, are characterized by the presence of a plurality of amide (-C(O)NH-) groups. In one embodiment, a polyamide polymer or material can include any one or more of those polyamide materials disclosed in in U.S. Pat. No. 4,970,272 to Gallucci. In a yet further embodiment, the polyamide resin or combination of polyamide resins has a melting point (Tm) greater than or equal to 171° C. In an even further embodiment, the polyamide comprises a super tough polyamide, that is, a rubber-toughened polyamide, the composition can or cannot contain a separate impact modifier.

Polyamide polymers having a comparatively high content of amine terminal groups can also be used.

Polyamides can be obtained by a number of well-known processes such as those described in U.S. Pat. Nos. 2,071,250, 2,071,251, 2,130,523, and 2,130,948 to Carothers; U.S. Pat. Nos. 2,241,322 and 2,312,966 to Hanford; and U.S. Pat. No. 2,512,606 to Bolton et al. In addition, polyamide resins are commercially available from a variety of sources.

Polyamides are generally derived from the polymerization of organic lactams having from 4 to 12 carbon atoms. In one embodiment, lactams are compounds having the formula:

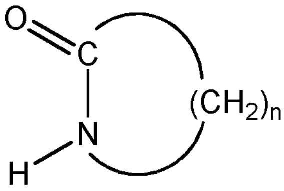

,

wherein n is an integer from 3 to 11. In a further embodiment, the lactam is ε-caprolactam having n equal to 5.

Polyamides can also be synthesized from amino acids having from 4 to 12 carbon atoms. In one embodiment, amino acids are compounds having the formula:

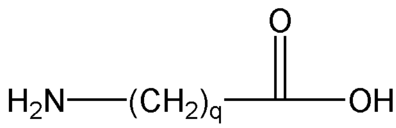

,

wherein q is an integer from 3 to 11. In a further embodiment, the amino acid is ε-aminocaproic acid with n equal to 5.

Polyamides can also be polymerized from aliphatic dicarboxylic acids having from 4 to 12 carbon atoms and aliphatic diamines having from 2 to 12 carbon atoms. For example, in one embodiment, aliphatic dicarboxylic acids have from 6 to 12 carbon atoms in the chain, and exemplary aliphatic dicarboxylic acids include suberic acid, sebacic acid, azelaic acid, adipic acid and the like. In a further embodiment, aliphatic diamines are compounds represented by the formula:

$$H_2N\text{-}(CH_2)_r\text{-}NH_2,$$

wherein r is an integer from 2 to 12. In a still further embodiment, the aliphatic diamine is hexamethylenediamine ($H_2N(CH_2)_6NH_2$).

In various embodiments, the molar ratio of the dicarboxylic acid to the diamine can be 0.66 to 1.5. In a further embodiment, the molar ratio is greater than or equal to 0.81. In a still further embodiment, the molar ration is greater than or equal to 0.96. In a yet further embodiment, the molar ratio is less than or equal to 1.22. In an even further embodiment, the molar ratio is less than or equal to 1.04.

Synthesis of polyamide esters can also be accomplished from aliphatic lactones having from 4 to 12 carbon atoms and aliphatic lactams having from 4 to 12 carbon atoms. The ratio of aliphatic lactone to aliphatic lactam can vary widely depending on the desired composition of the final copolymer, as well as the relative reactivity of the lactone and the lactam. In various embodiments, the initial molar ratio of aliphatic lactam to aliphatic lactone is 0.5 to 4. In a still further embodiment, the molar ratio is greater than or equal to 1. In a still further embodiment, the molar ratio is greater than or equal to 2.

Preparation of suitable polyamides can further include a catalyst or an initiator. Generally, any known catalyst or initiator suitable for the polymerization can be used. Alternatively, the polymerization can be conducted without a catalyst or initiator. For example, in the synthesis of polyamides from aliphatic dicarboxylic acids and aliphatic diamines, no catalyst is required.

For the synthesis of polyamides from lactams, suitable catalysts include water and the omega-amino acids corresponding to the ring-opened (hydrolyzed) lactam used in the synthesis. In various embodiments, additional suitable catalysts include metallic aluminum alkylates ($MAl(OR)_3H$, wherein M is an alkali metal or alkaline earth metal, and R is a $C_1$-$C_{12}$ alkyl moiety, sodium dihydro-bis(2-methoxyethoxy)aluminate, lithium dihydro-bis(tert-butoxy)aluminate, aluminum alkylates (e.g. $Al(OR)_2R$; wherein R is $C_1$-$C_{12}$ alkyl), N-sodium caprolactam, magnesium chloride or bromide salt of epsilon-caprolactam ($MgXC_6H_{10}NO$, X=Br or Cl), dialkoxy aluminum hydride. In a further embodiment, additional suitable initiators include isophthaloybiscaprolactam, N-acetalcaprolactam, isocyanate epsilon-caprolactam adducts, alcohols (R-OH; wherein R is $C_1$-$C_{12}$ alkyl), diols (HO-R-OH, wherein R is $C_1$-$C_{12}$ alkylene), omega-aminocaproic acids,

and sodium methoxide.

For the synthesis of polyamideesters from lactones and lactams, suitable catalysts include metal hydride compounds, such as a lithium aluminum hydride catalysts having the formula $LiAl(H)_x(R^1)_y$, where x is an integer from 1 to 4, y is an integer from 0 to 3, x+y is equal to 4, and $R^1$ is selected from $C_1$-$C_{12}$ alkyl and $C_1$-$C_{12}$ alkoxy; highly preferred catalysts include $LiAl(H)(OR^2)_3$, wherein $R^2$ is selected from the group consisting of $C_1$-$C_8$ alkyl. In a still further, the catalyst is $LiAl(H)(OC(CH_3)_3)_3$. Other suitable catalysts and initiators include those described above for the polymerization of poly($\varepsilon$-caprolactam) and poly($\varepsilon$-caprolactone).

In a further embodiment, the polyamide polymer used in the blended thermoplastic compositions has a weight average molecular weight from 10,000 Daltons to 40,000 Daltons (Da). In a still further embodiment, the polyamide polymer used in the blended thermoplastic compositions has a weight average molecular weight from 15,000 Daltons to 35,000 Daltons. In a yet further embodiment, the polyamide polymer used in the blended thermoplastic compositions has a weight average molecular weight from 20,000 Daltons to 30,000 Daltons.

In various embodiments, the polyamide polymer has a low viscosity. Polyamide resins having an intrinsic viscosity of up to 400 milliliters per gram (ml/g) can be used, or, more specifically, having a viscosity of 90 to 350 ml/g, or, even more specifically, having a viscosity of 110 to 240 ml/g, as measured in a 0.5 wt % solution in 96 wt % sulfuric acid in accordance with ISO 307.

In various further embodiments, the polyamide can have a relative viscosity of up to 6, or, more specifically, a relative viscosity of 1.89 to 5.43, or, even more specifically, a relative viscosity of 2.16 to 3.93. Relative viscosity is determined according to DIN 53727 in a 1 wt % solution in 96 wt % sulfuric acid.

In a further embodiment, the polyamide resin comprises a polyamide having an amine end group concentration greater than or equal to 35 microequivalents amine end group per gram of polyamide ($\mu$eq/g) as determined by titration with hydrochloric acid. The amine end group concentration can be greater than or equal to 40 $\mu$eq/g, more specifically 40 to 70 $\mu$eq/g. Amine end group content can be determined by dissolving the polyamide in a suitable solvent, optionally with heat. The polyamide solution is titrated with 0.01 Normal hydrochloric acid (HCl) solution using a suitable indication method. The amount of amine end groups is calculated based the volume of HCl solution added to the sample, the volume of HCl used for the blank, the molarity of the HCl solution, and the weight of the polyamide sample.

The first polyamide polymer is selected from polyamide 6 and polyamide 6,6; and the second polyamide polymer is selected from polyamide 10,10; polyamide 10,12; and polyamide 12,12.

In a further embodiment, the first polyamide polymer is present in an amount from 10 wt% to 90 wt%. In a still further embodiment, the first polyamide polymer is present in an amount from 20 wt% to 70 wt%. In a yet further embodiment, the first polyamide polymer is present in an amount from 30 wt% to 60 wt%.

In a further embodiment, the second polyamide polymer is present in an amount from 1 wt% to 40 wt%. In a still further embodiment, the second polyamide polymer is present in an amount from 5 wt% to 25 wt%. In a yet further embodiment, the second polyamide polymer is present in an amount from 5 wt% to 15 wt%.

In addition to the thermoplastic resin, the compositions of the present disclosure also include a laser direct structuring ("LDS") additive. The LDS additive is selected to enable the composition to be used in a laser direct structuring process. In an LDS process, a laser beam exposes the LDS additive to place it at the surface of the thermoplastic composition and to activate metal atoms from the LDS additive. As such, the LDS additive is selected such that, upon exposed to a laser beam, metal atoms are activated and exposed and in areas not exposed by the laser beam, no metal atoms are exposed. In addition, the LDS additive is selected such that, after being exposed to laser beam, the etching area is capable of being plated to form conductive structure. As used herein "capable of being plated" refers to a material wherein a substantially uniform metal plating layer can be plated on laser-etched area and show a wide window for laser parameters. This process is different than laser marking wherein the main outcome of laser marking is a color change in the material under the effect of energy radiation. And the key characterization for laser marking is the contrast between the mark and the substrate.

Conversely, for LDS, the goal is the formation of metal seeds on the laser etched surface, and the final metallization layer during the following plating process. Plating rate and adhesion of plated layers are the key evaluation requirements. Color here means the substrate made from these materials itself not the color change under the laser radiation. As such, in addition to enabling the composition to be used in a laser direct structuring process, the LDS additive used in the present disclosure is also selected to help enable the composition to be colored while maintaining physical properties.

According to various embodiments of the present disclosure, the laser direct structuring additive can comprise one or more metal oxides, including for example, oxides of chromium, copper, or combinations thereof. These laser direct structuring additives can also be provided having spinel type crystal structures. An exemplary and non-limiting example of a commercially available laser direct structuring additive includes PK3095 black pigment, commercially available from Ferro Corp., USA. PK3095, for example, comprises chromium oxides ($Cr_2O_3$, $Cr_2O_4^{2-}$, $Cr_2O_7^{2-}$) and oxides of copper (CuO), as determined using XPS. The PK3095 black pigment also has a spinel type crystal structure. Another exemplary commercially available laser direct structuring additive is the Black 1G pigment black 28 commercially

available from The Shepherd Color company. The Black 1G pigment black 28 comprises copper chromate and has a pH of 7.3. The Black 1G pigment also has a spinel type crystal structure.

Current additives for LDS materials are usually spinel based metal oxides (such as copper chromium oxide), organic metal complexes (such as palladium/palladium-containing heavy metal complexes) or copper complexes there are some limitations based on these additives. However, spinel based metal oxides result in a black color. In addition, with organic metal complex, higher loadings are needed to obtain sufficiently dense nucleation for rapid metallization when activated, and these higher amounts adversely affect the mechanical properties of the materials.

LDS additives that enable coloring of the material while retaining mechanical strength of the composition can also be used in the present disclosure. Examples of useful LDS additives include, but are not limited to, a metal oxide-coated filler. In one embodiment, the LDS additive is antimony doped tin oxide coating on a mica substrate. Other examples include a coating including a copper containing metal oxide, a titanium containing metal oxide, a tin containing metal oxide, a zinc containing metal oxide, a magnesium containing metal oxide, an aluminum containing metal oxide, a gold containing metal oxide, a silver containing metal oxide, or a combination including at least one of the foregoing metal oxides, and the substrate can be any other mineral, such as silica.

Examples of laser direct structuring additives include, but are not limited to, a metal oxide, a metal-oxide coated filler, and a heavy metal mixture oxide spinel, such as copper chromium oxide spinel; a copper salt, such as copper hydroxide phosphate copper phosphate, copper sulfate, cuprous thiocyanato; organic metal complexes, such as palladium/palladium-containing heavy metal complexes or copper complexes; or a combination including at least one of the foregoing LDS additives. In a further embodiment, the laser direct structure additive is a metal oxide selected from a copper-containing metal oxide, a titanium-containing metal oxide, a tin-containing metal oxide, a zinc-containing metal oxide, a magnesium-containing metal oxide, an aluminum-containing metal oxide, a gold-containing metal oxide, and a silver-containing metal oxide, or a combination thereof.

Further non-limiting examples of suitable metal oxide materials that can be used as a laser direct structuring additive include antimony doped tin oxide coating on a mineral substrate, a copper containing metal oxide coating on a mineral substrate, a zinc containing metal oxide coating on a mineral substrate, a tin containing metal oxide coating on a mineral substrate, a magnesium containing metal oxide coating on a mineral substrate, an aluminum containing metal oxide coating on a mineral substrate, a gold containing metal oxide coating on a mineral substrate, a silver containing metal oxide coating on a mineral substrate, or a combination thereof. The mineral substrate can be a variety of mineral materials including silica and mica.

In various embodiments, the laser direct structuring (LDS) additive is selected from a heavy metal mixture oxide spinel, a copper salt, or a combination including at least one of the foregoing laser direct structuring additives. In a further embodiment, the laser direct structuring (LDS) additive comprises a combination of copper chromium oxide and at least one additional additive selected from a heavy metal mixture oxide spinel, or a copper salt.

In a further embodiment, the laser direct structure additive is a copper-containing material. In a still further embodiment, the copper-containing material is copper hydroxide phosphate. In a yet further embodiment, the laser direct structuring (LDS) additive comprises copper chromium oxide. In a still further embodiment, the laser direct structuring (LDS) additive consists essentially of copper chromium oxide. In a still further embodiment, the laser direct structuring (LDS) additive consists essentially of copper hydroxide phosphate.

In a further embodiment, the LDS is a metal-oxide coated filler is antimony doped tin oxide coating on a mica substrate, a copper-containing metal oxide, a zinc-containing metal oxide, a tin-containing metal oxide, a magnesium-containing metal oxide, an aluminum-containing metal oxide, a gold-containing metal oxide, and a silver-containing metal oxide, or a combination including at least one of the foregoing metal oxides, and the substrate may be any other mineral, such as silica.

The amount of the LDS additive included is sufficient to enable plating of the track formed after activation by the laser while not adversely affecting mechanical properties.

The laser direct structure additive is present in an amount from 0.5 wt% to 20 wt%. In an even further embodiment, the laser direct structure additive is present in an amount from 0.5 wt% to 10 wt%. In a still further embodiment, the laser direct structure additive is present in an amount from 0.5 wt% to 5 wt%. In yet a further embodiment, the laser direct structure additive is present in an amount from 1 wt% to 5 wt%. In a yet further embodiment, the LDS additive is present in amounts from a1 to 15 wt%. In a still another embodiment, the LDS additive is present in amounts from 2 to 10 wt%. In an even further, the LDS additive is present in amounts from 2 to 10 wt%.

As discussed, the LDS additive is selected such that, after activating with a laser, the conductive path can be formed by followed a standard electroless plating process. When the LDS additive is exposed to the laser, elemental metal is released. The laser draws the circuit pattern onto the part and leaves behind a roughened surface containing embedded metal particles. These particles act as nuclei for the crystal growth during a subsequent plating process, such as a copper plating process. Other electroless plating processes that can be used include, but are not limited to, gold plating, nickel plating, silver plating, zinc plating, tin plating or the like.

In various embodiments, the blended thermoplastic compositions of the present disclosure comprise one or

more thermally conductive fillers.

The thermally conductive filler is selected from a high thermally conductive filler ; wherein the high thermally conductive filler has a thermal conductivity greater than or equal to 50 W/mK.

Examples of high thermally conductive filler include, but are not limited to, AlN (aluminum nitride), $Al_4C_3$ (aluminum carbide), $Al_2O_3$ (aluminum oxide), BN (boron nitride), AlON (aluminum oxynitride), $MgSiN_2$ (magnesium silicon nitride), SiC (silicon carbide), $Si_3N_4$ (silicon nitride), graphite, expanded graphite, graphene, and carbon fiber. In a still further embodiment, the high thermally conductive filler is selected from AlN, $Al_4C_3$, $Al_2O_3$, BN, AlON, $MgSiN_2$, SiC, $Si_3N_4$, graphite, expanded graphite, graphene, and carbon fiber, or combinations thereof. In a still further embodiment, the high thermally conductive filler is selected from AlN, $Al_2O_3$, BN, SiC, graphite, expanded graphite, and carbon fiber, or combinations thereof. In yet a further embodiment, the high thermally conductive filler is selected from BN, graphite, and expanded graphite, or combinations thereof. In an even further embodiment, the high thermally conductive filler is selected from AlN, $Al_2O_3$, SiC, and carbon fiber, or combinations thereof. In a still further embodiment, the high thermally conductive filler is selected from BN, graphite, and expanded graphite, or combinations thereof.

In various embodiments, the intrinsic thermal conductivity of the high thermally conductive filler is greater than or equal to 50 W/mK. In a further embodiment, the intrinsic thermal conductivity of the high thermally conductive filler is greater than or equal to 100 W/mK. In a still further embodiment, the intrinsic thermal conductivity of the high thermally conductive filler is greater than or equal to 150 W/mK.

In an embodiment, the thermally conductive filler is present in an amount from 10 wt% to 40 wt%.

The graphite used in the present disclosure can be synthetically produced or naturally produced, or can be expandable graphite or expanded graphite with a thickness smaller than 1 micrometer ($\mu$m). In one embodiment, the graphite is naturally produced. There are three types of naturally produced graphite that are commercially available. They are flake graphite, amorphous graphite and crystal vein graphite. In one embodiment, the graphite is flake graphite, wherein the flake graphite is typically found as discrete flakes ranging in size from 10 to 800 micrometers in diameter and 1 to 150 micrometers thick and purities ranging from 80 to 99.9% carbon. In another embodiment the graphite is spherical.

The boron nitride used in the disclosure is typically hexagonal boron nitride (h- BN), which can be complete h-BN or turbostratic boron nitride (t-BN). The BN particle can be large sized single BN crystal powder, agglomerate of small sized BN particles, the mixture thereof, the agglomerated spherical powder, or BN fiber. In one embodiment, the BN average particle size or $D_{50}$ in diameter can range from 1 to 500 micrometers. In another embodiment, within this range, the boron nitride particles have a size of greater than or equal to 3, or greater than or equal to 5 micrometers. The particle size indicated here means the single BN particle or its agglomerate at any of their dimensions. In one embodiment, the BN has a BN purity ranging from 95% to 99.8%. In one embodiment, a large single crystal sized flake BN with an average size ranging from 3 to 50 micrometers and a BN purity of over 98% is used.

In a further embodiment, the thermally conductive filler comprises a sizing or coating material. In a still further embodiment, the thermally conductive filler is coated with an amino-silane, polyurethane, vinyl-silane, epoxy-silane, or epoxy. In a yet further embodiment, the blended thermoplastic composition comprises a polyamide; and at least one thermally conductive filler coated with an amino silane.

In various embodiments, the blended thermoplastic compositions of the present disclosure can further comprise one or more thermally insulating fillers can be used. Examples of thermally insulating fillers include, but are not limited to, $H_2Mg_3(SiO_3)_4$ (Talc), $CaCO_3$ (calcium carbonate), $Mg(OH)_2$ (magnesium hydroxide), mica, BaO (barium oxide), $\gamma$-AlO(OH) (boehmite), $\alpha$-AlO(OH) (diaspore), $Al(OH)_3$ (gibbsite), $BaSO_4$ (barium sulfate), $CaSiO_3$ (wollastonite), $ZrO_2$ (zirconium oxide), $SiO_2$ (silicon oxide), glass beads, glass fiber, $MgO{\bullet}xAl_2O_3$ (magnesium aluminate), $CaMg(CO_3)_2$ (dolomite), ceramic-coated graphite, and various types of clay, or a combinations thereof.

In a further embodiment, the thermally insulating filler is selected from $Mg(OH)_2$, $CaCO_3$, mica, $\gamma$-AlO(OH), BaO, $BaSO_4$, AlO(OH), $CaSiO_3$, $ZrO_2$, $SiO_2$, glass beads, glass fiber, $H_2Mg_3(SiO_3)_4$, $AL(OH)_3$, $MgO{\bullet}xAl_2O_3$, $CaMg(CO_3)_2$, ceramic-coated graphite, and clay, or combinations thereof. In a still further embodiment, the thermally insulating filler is selected from $Mg(OH)_2$, $CaCO_3$, mica, $\gamma$-AlO(OH), $SiO_2$, glass beads, glass fiber, $H_2Mg_3(SiO_3)_4$, $Al(OH)_3$, and clay, or combinations thereof. In yet a further embodiment, the thermally insulating filler is selected from $Mg(OH)_2$, glass fiber, $H_2Mg_3(SiO_3)_4$, and $Al(OH)_3$, or combinations thereof. In an even further embodiment, the thermally insulating filler is selected from $CaCO_3$, $\gamma$-AlO(OH), $SiO_2$, glass beads, and clay. In a still further embodiment, the thermally insulating filler is selected from $Mg(OH)_2$, glass fiber, $H_2Mg_3(SiO_3)_4$, and $Al(OH)_3$, or combinations thereof.

In a further embodiment, the thermally insulating filler has an intrinsic thermal conductivity less than or equal to 10 W/mK. In a still further embodiment, the intrinsic thermal conductivity of the thermally insulating filler is less than or equal to 7.5 W/mK. In a yet further embodiment, the intrinsic thermal conductivity of the thermally insulating filler is less than or equal to 5 W/mK.

In a further embodiment, the thermally insulating filler comprises a sizing or coating material. In a still further embodiment, the thermally insulating filler is coated with an amino-silane, polyurethane, vinyl-silane, epoxy-silane, or epoxy. In a yet further embodiment, the blended thermoplastic composition comprises a polyamide; and at least one

thermally insulating filler coated with an amino silane.

In a further embodiment, the blended thermoplastic composition comprises a polyamide and at least one thermally insulating filler that is amino-silane coated.

The disclosed polymer compositions further comprise an reinforcing filler, such as, for example, an inorganic filler or reinforcing agent. The specific composition of a filler, can vary, provided that the filler is chemically compatible with the remaining components of the polymer composition. In one embodiment, the polymer composition comprises a mineral filler. In another embodiment, the polymer composition comprises a filler comprising talc. In another embodiment, the polymer composition comprises a filler comprising a carbon fiber. In another embodiment, the polymer composition comprises a filler comprising a glass fiber.

In a further embodiment, the disclosed polymer compositions further comprise a filler selected from amino-silane treated fillers, polyurethane treated fillers, vinyl-silane treated fillers, epoxy-silane treated fillers, and epoxy treated fillers, or a combination thereof.

In another embodiment, an exemplary filler can comprise silicates and silica powders, such as aluminum silicate (mullite), synthetic calcium silicate, zirconium silicate, fused silica, crystalline silica graphite, natural silica sand, or the like; boron powders, , boron-silicate powders, or the like; oxides, such as aluminum oxide, magnesium oxide, or the like; calcium sulfate (as its anhydride, dihydrate or trihydrate), or the like; glass spheres such as hollow and solid glass spheres, silicate spheres, aluminosilicate, or the like; kaolin, including hard kaolin, soft kaolin, calcined kaolin, kaolin comprising various coatings known in the art to facilitate compatibility with the polymeric matrix resin, or the like; single crystal fibers or "whiskers" such as silicon carbide, alumina, boron carbide, iron, nickel, copper, or the like; fibers (including continuous and chopped fibers), sulfides such as molybdenum sulfide, zinc sulfide or the like; and metal oxides such as particulate or fibrous aluminum, bronze, zinc, copper and nickel or the like; flaked fillers such as glass flakes, flaked silicon carbide, aluminum diboride, aluminum flakes, steel flakes or the like; fibrous fillers, for example short inorganic fibers such as those derived from blends comprising at least one of aluminum silicates, aluminum oxides, magnesium oxides, and calcium sulfate hemihydrate or the like; natural fillers and reinforcements, such as wood flour obtained by pulverizing wood, fibrous products such as cellulose, cotton, or the like; combinations comprising at least one of the foregoing fillers or reinforcing agents.

The disclosed polymer compositions can optionally comprise one or more additives conventionally used in the manufacture of molded thermoplastic parts with the proviso that the optional additives do not adversely affect the desired properties of the resulting composition. Mixtures of optional additives can also be used. Such additives can be mixed at a suitable time during the mixing of the components for forming the composite mixture. For example, the disclosed compositions can comprise one or more lubricants, plasticizers, ultraviolet light absorbing additives, anti-dripping agents, dyes, pigments, stabilizers, anti-static agents, flame-retardants, impact modifiers, colorants, antioxidant, and/or mold release agents. In one embodiment, the composition further comprises one or more optional additives selected from an antioxidant, flame retardant, and stabilizer. In a further embodiment, the composition further comprises a flame retardant.

Exemplary heat stabilizers include, for example, organophosphites such as triphenylphosphite, tris-(2,6-dimethylphenyl)phosphite, tris-(mixed mono-and dinonylphenyl)phosphite or the like; phosphonates such as dimethylbenzenephosphonate or the like, phosphates such as trimethyl phosphate, or the like, or combinations including at least one of the foregoing heat stabilizers. Heat stabilizers are generally used in amounts of from 0.01 to 0.5 parts by weight based on 100 parts by weight of the total composition, excluding any filler.

Exemplary antioxidants include, for example, organophosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di-tert-butyl-4-hydroxyhydrocinnamate)] methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearyl thiopropionate, dilauryl thiopropionate, ditridecyl thiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate or the like; amides of beta-(3,5-di-tert-butyl-4-hydroxyphenyl)-propionic acid or the like, or combinations including at least one of the foregoing antioxidants. Antioxidants are generally used in amounts of from 0.01 to 0.5 parts by weight, based on 100 parts by weight of the total composition, excluding any filler.

Exemplary light stabilizers include, for example, benzotriazoles such as 2-(2-hydroxy-5-methylphenyl)benzotriazole, 2-(2-hydroxy-5 -tert-octylphenyl)-benzotriazo le and 2-hydroxy-4-n-octoxy benzophenone or the like or combinations including at least one of the foregoing light stabilizers. Light stabilizers are generally used in amounts of from 0.1 to 1.0 parts by weight, based on 100 parts by weight of the total composition, excluding any filler.

Exemplary plasticizers include, for example, phthalic acid esters such as dioctyl-4,5-epoxy-hexahydrophthalate, tris-(octoxycarbonylethyl) isocyanurate, tristearin, epoxidized soybean oil or the like, or combinations including at least one of the foregoing plasticizers. Plasticizers are generally used in amounts of from 0.5 to 3.0 parts by weight, based

on 100 parts by weight of the total composition, excluding any filler.

Exemplary antistatic agents include, for example, glycerol monostearate, sodium stearylsulfonate, sodium dodecylbenzenesulfonate or the like, or combinations of the foregoing antistatic agents. In one embodiment, carbon fibers, carbon nanofibers, carbon nanotubes, carbon black, or any combination of the foregoing can be used in a polymeric resin containing chemical antistatic agents to render the composition electrostatically dissipative.

Exemplary mold releasing agents include for example, metal stearate, stearyl stearate, pentaerythritol tetrastearate, beeswax, montan wax, paraffin wax, or the like, or combinations including at least one of the foregoing mold release agents. Mold releasing agents are generally used in amounts of from 0.1 to 1.0 parts by weight, based on 100 parts by weight of the total composition, excluding any filler.

Exemplary UV absorbers include for example, hydroxybenzophenones; hydroxybenzotriazoles; hydroxybenzotriazines; cyanoacrylates; oxanilides; benzoxazinones; 2-(2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]-5-(octyloxy)-phenol (CYASORB™ 1164); 2,2'-(1,4- phenylene)bis(4H-3,1-benzoxazin-4-one)(CYASORB™ UV- 3638); 1,3-bis[(2-cyano-3,3-diphenylacryloyl)oxy]-2,2-bis[[(2-cyano-3,3-diphenylacryloyl)oxy]methyl]propane (UVINUL™ 3030); 2,2'-(1,4-phenylene) bis(4H-3,1-benzoxazin-4-one); 1,3-bis[(2-cyano-3,3-diphenylacryloyl)oxy]-2,2-bis[[(2-cyano-3,3-diphenylacryloyl)oxy]methyl]propane; nano-size inorganic materials such as titanium oxide, cerium oxide, and zinc oxide, all with particle size less than 100 nanometers (nm); or the like, or combinations including at least one of the foregoing UV absorbers. UV absorbers are generally used in amounts of from 0.01 to 3.0 parts by weight, based on 100 parts by weight of the total composition, excluding any filler.

Exemplary lubricants include for example, fatty acid esters such as alkyl stearyl esters, e.g., methyl stearate or the like; mixtures of methyl stearate and hydrophilic and hydrophobic surfactants including polyethylene glycol polymers, polypropylene glycol polymers, and copolymers thereof e.g., methyl stearate and polyethylene-polypropylene glycol copolymers in a suitable solvent; or combinations including at least one of the foregoing lubricants. Lubricants are generally used in amounts of from 0.1 to 5 parts by weight, based on 100 parts by weight of the total composition, excluding any filler.

Exemplary blowing agents include for example, low boiling halo hydrocarbons and those that generate carbon dioxide; blowing agents that are solid at room temperature and when heated to temperatures higher than their decomposition temperature, generate gases such as nitrogen, carbon dioxide, ammonia gas, such as azodicarbonamide, metal salts of azodicarbonamide, 4,4'-oxybis(benzenesulfonyl hydrazide), sodium bicarbonate, ammonium carbonate, or the like, or combinations including at least one of the foregoing blowing agents. Blowing agents are generally used in amounts of from 1 to 20 parts by weight, based on 100 parts by weight of the total composition, excluding any filler.

As noted above, the disclosed polymer compositions can optionally further comprise a flame retardant additive. In various embodiments, the flame retardant additive can comprise any flame retardant material or mixture of flame retardant materials suitable for use in the inventive polymer compositions.

In a further embodiment, the flame retardant additive comprises a phosphate containing material. In a yet further embodiment, the flame retardant additive comprises a phosphate containing material selected from a phosphine, a phosphine oxide, a bisphosphine, a phosphonium salt, a phosphinic acid salt, a phosphoric ester, and a phosphorous ester, or a combination thereof.

In a further embodiment, the flame retardant additive comprises a halogen containing material. In other embodiments, the flame retardant additive is free of or substantially free of one or more of phosphate and/or a halogen.

In a further embodiment, the flame retardant additive comprises an oligomer organophosphorous flame retardant, including for example, bisphenol A diphenyl phosphate ("BPADP"). In a yet further embodiment, the flame retardant is selected from aromatic polyphosphate oligomers, phenoxyphosphazene oligomers, melamine polyphosphate oligomers, and metal phosphinate oligomers, or a combination thereof. In a still further embodiment, the flame retardant is selected from oligomeric phosphate, polymeric phosphate, oligomeric phosphonate, or mixed phosphate/phosphonate ester flame retardant compositions. In an even further embodiment, the flame retardant is selected from bisphenol-A bis(diphenyl phosphate), 1,3-phenylene tetraphenyl ester, bisphenol-A bis(diphenyl phosphate), red phosphorous, and Clariant Exolite OP series FR, or a combination thereof. In a still further embodiment, the flame retardant is selected from triphenyl phosphate; cresyl diphenylphosphate; tri(isopropylphenyl)phosphate; resorcinol bis(diphenyl phosphate); and bisphenol-A bis(diphenyl phosphate). In a yet further embodiment, the flame retardant is bisphenol-A bis(diphenyl phosphate).

Additionally, materials to improve flow and other properties can be added to the composition, such as low molecular weight hydrocarbon resins. Particularly useful classes of low molecular weight hydrocarbon resins are those derived from petroleum $C_5$ to $C_9$ feedstock that are derived from unsaturated $C_5$ to $C_9$ monomers obtained from petroleum cracking. Non-limiting examples include olefins, e.g., pentenes, hexenes, heptenes and the like; diolefins, e.g., pentadienes, hexadienes and the like; cyclic olefins and diolefins, e.g., cyclopentene, cyclopentadiene, cyclohexene, cyclohexadiene, methyl cyclopentadiene and the like; cyclic diolefin dienes, e.g., dicyclopentadiene, methylcyclopentadiene dimer and the like; and aromatic hydrocarbons, e.g., vinyl toluenes, indenes, methylindenes and the like. The resins can

additionally be partially or fully hydrogenated.

The compositions of the present disclosure can be blended with the aforementioned ingredients by a variety of methods involving intimate admixing of the materials with any additional additives desired in the formulation. Because of the availability of melt blending equipment in commercial polymer processing facilities, melt processing methods are generally preferred. Illustrative examples of equipment used in such melt processing methods include: co-rotating and counter-rotating extruders, single screw extruders, co-kneaders, disc-pack processors and various other types of extrusion equipment. The temperature of the melt in the present process is preferably minimized in order to avoid excessive degradation of the resins. It is often desirable to maintain the melt temperature between 230°C and 350°C in the molten resin composition, although higher temperatures can be used provided that the residence time of the resin in the processing equipment is kept short. In some embodiments the melt processed composition exits processing equipment such as an extruder through small exit holes in a die. The resulting strands of molten resin are cooled by passing the strands through a water bath. The cooled strands can be chopped into small pellets for packaging and further handling.

Compositions can be manufactured by various methods. For example, polymer , and/or other optional components are first blended, optionally with fillers in a HENSCHEL-Mixer™ high speed mixer. Other low shear processes, including but not limited to hand mixing, can also accomplish this blending. The blend is then fed into the throat of a twin-screw extruder via a hopper. Alternatively, at least one of the components can be incorporated into the composition by feeding directly into the extruder at the throat and/or downstream through a sidestuffer. Additives can also be compounded into a masterbatch with a desired polymeric resin and fed into the extruder. The extruder is generally operated at a temperature higher than that necessary to cause the composition to flow. The extrudate is immediately quenched in a water batch and pelletized. The pellets, so prepared, when cutting the extrudate can be one-fourth inch long or less as desired. Such pellets can be used for subsequent molding, shaping, or forming.

In one embodiment, the laser direct structuring process involves three steps: 1) injection molding, 2) laser structuring, and 3) metallizing.

In a further embodiment, during the injection molding step, the laser direct structuring additive and reinforcing filler can be mixed with the thermoplastic polymer. In another embodiment, the blend composition further comprises one or more optional additives selected from an antioxidant, flame retardant, inorganic filler, and stabilizer. In a still further embodiment, single shot injection molding can be used to produce the parts or articles to be laser structured. In at least one embodiment, the polymer composition can be mixed at this step and used in the LDS process. In another embodiment, additional ingredients can be added to the polymer composition after this step.

In a further embodiment, during the laser structuring step, a laser is used to form a conductive path during the laser structuring step. In a still further embodiment, the laser used to form a conductive path is laser direct structuring. In a yet further embodiment, laser direct structuring comprises laser etching. In an even further embodiment, laser etching is carried out to provide an activated surface.

In a further embodiment, at least one laser beam draws at least one pattern on the surface of the polymer composition during the laser structuring step. In a still further embodiment, the employed filler composition can release at least one metallic nucleus. In a yet further embodiment, the at least one metallic nucleus that has been released can act as a catalyst for reductive copper plating process.

Laser direct structuring is can be carried out on an article comprising the disclosed blended thermoplastic compositions at a power setting from 1 watt (W) to 14 W, a frequency from 30 kilohertz (kHz) to 120 kHz, and a speed of 1 meter per second (m/s) to 5 m/s. In a further embodiment, laser etching is carried out at 1 W to 10 W power with a frequency from 30 kHz to 110 kHz and a speed of 1 m/s to 5 m/s. In a still further embodiment, laser etching is carried out at 1 W to 10 W power with a frequency from 40 kHz to 100 kHz and a speed of 2 m/s to 4 m/s. In a yet further embodiment, laser etching is carried out at 3.5 W power with a frequency of 40 kHz and a speed of 2 m/s.

In various embodiments, laser direct structuring is carried out on an article comprising the disclosed blended thermoplastic compositions at a power setting of 2 W. In a further embodiment, laser direct structuring is carried out on an article comprising the disclosed blended thermoplastic compositions at a power setting of 3 W. In a still further embodiment, laser direct structuring is carried out on an article comprising the disclosed blended thermoplastic compositions at a power setting of 4 W. In a yet further embodiment, laser direct structuring is carried out on an article comprising the disclosed blended thermoplastic compositions at a power setting of 5 W. In an even further embodiment, laser direct structuring is carried out on an article comprising the disclosed blended thermoplastic compositions at a power setting of 6 W. In a still further embodiment, laser direct structuring is carried out on an article comprising the disclosed blended thermoplastic compositions at a power setting of 7 W. In a yet further embodiment, laser direct structuring is carried out on an article comprising the disclosed blended thermoplastic compositions at a power setting of 8 W. In an even further embodiment, laser direct structuring is carried out on an article comprising the disclosed blended thermoplastic compositions at a power setting of 9 W. In a still further embodiment, laser direct structuring is carried out on an article comprising the disclosed blended thermoplastic compositions at a power setting of 10 W. In a yet further embodiment, laser direct structuring is carried out on an article comprising the disclosed blended thermoplastic compositions at a power setting of 11 W.

In various embodiments, laser direct structuring is carried out on an article comprising the disclosed blended thermoplastic compositions at a frequency setting of 40 kHz. In a further embodiment, laser direct structuring is carried out on an article comprising the disclosed blended thermoplastic compositions at a frequency setting of 50 kHz. In a still further embodiment, laser direct structuring is carried out on an article comprising the disclosed blended thermoplastic compositions at a frequency setting of 60 kHz. In a yet further embodiment, laser direct structuring is carried out on an article comprising the disclosed blended thermoplastic compositions at a frequency setting of 70 kHz. In an even further embodiment, laser direct structuring is carried out on an article comprising the disclosed blended thermoplastic compositions at a frequency setting of 80 kHz. In a still further embodiment, laser direct structuring is carried out on an article comprising the disclosed blended thermoplastic compositions at a frequency setting of 90 kHz. In a yet further embodiment, laser direct structuring is carried out on an article comprising the disclosed blended thermoplastic compositions at a frequency setting of 100 kHz. In an even further embodiment, laser direct structuring is carried out on an article comprising the disclosed blended thermoplastic compositions at a frequency setting of 110 kHz. In a still further embodiment, laser direct structuring is carried out on an article comprising the disclosed blended thermoplastic compositions at a frequency setting of 120 kHz.

In various embodiments, laser direct structuring is carried out on an article comprising the disclosed blended thermoplastic compositions at a speed of 1 m/s. In a further embodiment, laser direct structuring is carried out on an article comprising the disclosed blended thermoplastic compositions at a speed of 2 m/s. In a still further embodiment, laser direct structuring is carried out on an article comprising the disclosed blended thermoplastic compositions at a speed of 3 m/s. In a yet further embodiment, laser direct structuring is carried out on an article comprising the disclosed blended thermoplastic compositions at a speed of 4 m/s. In an even further embodiment, laser direct structuring is carried out on an article comprising the disclosed blended thermoplastic compositions at a speed of 5 m/s.

In a further embodiment, a rough surface can form in the LDS process. In a still further embodiment, the rough surface can entangle the copper plate with the polymer matrix in the polymer composition, which can provide adhesion between the copper plate and the polymer composition. The metalizing step can, in various embodiments, be performed using conventional techniques. For example, in one embodiment, an electroless copper plating bath is used during the metallization step in the LDS process. Thus, in various embodiments, plating a metal layer onto a conductive path is metallization. In a still further embodiment, metallization can comprise the steps: a) cleaning the etched surface; b) additive build-up of tracks; and c) plating.

Shaped, formed, or molded articles including the polymer compositions are also provided. The polymer compositions can be molded into useful shaped articles by a variety of means such as injection molding, extrusion, rotational molding, blow molding and thermoforming to form articles such as, for example, personal computers, notebook and portable computers, cell phone antennas and other such communications equipment, medical applications, radiofrequency identification ("RFID") applications, automotive applications, and the like.

The blended polymer compositions, disclosed herein provide robust plating performance while maintaining good mechanical properties. Evaluation of the mechanical properties can be performed through various tests, such as Izod impact test (notched and/or unnotched), Charpy test, Gardner test, etc., according to several standards (e.g., ASTM D256). Robustness of plating performance can be measured via a performance ranking, or plating ranking, ranging from top performance (e.g., "best") to bottom performance. The ranking can be partitioned in various levels. In one embodiment, a plating ranking can have a level of "10" for top performance and a level of "0" for bottom performance.

In a further embodiment, the method comprises forming a molded part from the composition. In another embodiment, the method further comprises subjecting the molded part to a laser direct structuring process.

In one embodiment, the article comprises the product of extrusion molding or injection molding a composition comprising a thermoplastic polymer, a laser directing structuring additive and a reinforcing filler.

In a further embodiment, the molded article further comprises a conductive path formed by activation with a laser. In a yet further embodiment, the article further comprises a metal layer plated onto the conductive path. In an even further embodiment, the metal layer is a copper layer. In a still further embodiment, the metal layer has a thickness of 0.8 micrometers or higher as measured according to ASTM B568.

In various embodiments, the polymer composition can be used in the field of electronics. In a further embodiment, non-limiting examples of fields which can use the disclosed blended polymer compositions include electrical, electromechanical, Radio Frequency ("RF") technology, telecommunication, automotive, aviation, medical, sensor, military, and security. In a still further embodiment, the use of the disclosed blended polymer compositions can also be present in overlapping fields, for example in mechatronic systems that integrate mechanical and electrical properties which may, for example, be used in automotive or medical engineering.

In one embodiment, molded articles according to the present disclosure can be used to produce a device in one or more of the foregoing fields. In a still further embodiment, non-limiting examples of such devices in these fields which can use the disclosed blended polymer compositions according to the present disclosure include computer devices, household appliances, decoration devices, electromagnetic interference devices, printed circuits, Wi-Fi devices, Bluetooth devices, global positioning system ("GPS") devices, cellular antenna devices, smart phone devices, automotive

devices, military devices, aerospace devices, medical devices, such as hearing aids, sensor devices, security devices, shielding devices, RF antenna devices, LED devices, or RFID devices. In yet a further embodiment, the device is selected from a computer device, electromagnetic interference device, automotive device, medical device, sensor device, security device, shielding device, RF antenna device, LED device and RFID device. In an even further embodiment, the device is selected from a computer device, sensor device, security device, RF antenna device, LED device and RFID device. In a still further embodiment, the device is selected from a computer device, LED device and RFID device. In yet a further embodiment, the device is a LED device. In an even further embodiment, the device is a LED lamp.

In a still further embodiment, the molded articles can be used to manufacture devices in the automotive field. In a further embodiment, non-limiting examples of such devices in the automotive field which can use the disclosed blended polymer compositions in the vehicle's interior include adaptive cruise control, headlight sensors, windshield wiper sensors, and door/window switches. In a further embodiment, non-limiting examples of devices in the automotive field which can use the disclosed blended polymer compositions in the vehicle's exterior include pressure and flow sensors for engine management, air conditioning, crash detection, and exterior lighting fixtures.

In a further embodiment, the resulting disclosed compositions can be used to provide any desired shaped, formed, or molded articles. For example, the disclosed compositions can be molded into useful shaped articles by a variety of means such as injection molding, extrusion, rotational molding, blow molding and thermoforming. As noted above, the disclosed compositions are particularly well suited for use in the manufacture of electronic components and devices. As such, according to some embodiments, the disclosed compositions can be used to form articles such as printed circuit board carriers, burn in test sockets, flex brackets for hard disk drives, and the like.

In various embodiments, a molded article comprising the disclosed blended thermoplastic compositions can have a melt volume rate ("MVR") from 10 cubic centimeters per 10 minutes ($cm^3/10$ min) to 300 $cm^3/10$ min when determined in accordance with ASTM D1238 under a load of 5.0 kilograms (kg) and at a temperature of 275°C. In a further embodiment, a molded article comprising the disclosed blended thermoplastic compositions can have a melt volume rate (MVR) from 30 $cm^3/10$ min to 250 $cm^3/10$ min when determined in accordance with ASTM D1238 under a load of 5.0 kg and at a temperature of 275°C. In a still further embodiment, a molded article comprising the disclosed blended thermoplastic compositions can have a melt volume rate (MVR) from 50 $cm^3/10$ min to 200 $cm^3/10$ min when determined in accordance with ASTM D1238 under a load of 5.0 kg and at a temperature of 275 °C.

In various embodiments, a molded article comprising the disclosed blended thermoplastic compositions can have a modulus of elasticity from 2,000 megapascals (MPa) to 18,000 MPa when determined in accordance with ASTM D638 at a speed of 5 millimeters per minute (mm/min). In a further embodiment, a molded article comprising the disclosed blended thermoplastic compositions can have a modulus of elasticity from 3,000 MPa to 16,000 MPa when determined in accordance with ASTM D638 at a speed of 5 mm/min. In a still further embodiment, a molded article comprising the disclosed blended thermoplastic compositions can have a modulus of elasticity from 5,000 MPa to 15,000 MPa when determined in accordance with ASTM D638 at a speed of 5 mm/min.

In various embodiments, a molded article comprising the disclosed blended thermoplastic compositions can have a tensile stress at break from 20 MPa to 200 MPa when determined in accordance with ASTM D638 at a speed of 5 mm/min. In a further embodiment, a molded article comprising the disclosed blended thermoplastic compositions can have a tensile stress at break from 40 MPa to 150 MPa when determined in accordance with ASTM D638 at a speed of 5 mm/min. In a still further embodiment, a molded article comprising the disclosed blended thermoplastic compositions can have a tensile stress at break from 50 MPa to 100 MPa when determined in accordance with ASTM D638 at a speed of 5 mm/min.

In various embodiments, a molded article comprising the disclosed blended thermoplastic compositions can have a tensile elongation at break from 0.5% to 5% when determined in accordance with ASTM D638 at a speed of 5 mm/min. In a further embodiment, a molded article comprising the disclosed blended thermoplastic compositions can have a tensile elongation at break from 0.5% to 3% when determined in accordance with ASTM D638 at a speed of 5 mm/min. In a still further embodiment, a molded article comprising the disclosed blended thermoplastic compositions can have a tensile elongation at break from 0.5% to 1.5% when determined in accordance with ASTM D638 at a speed of 5 mm/min.

In various embodiments, a molded article comprising the disclosed blended thermoplastic compositions can have a flexural modulus from 2,000 MPa to 20,000 MPa when determined in accordance with ASTM D790 at a speed of 1.27 mm/min. In a further embodiment, a molded article comprising the disclosed blended thermoplastic compositions can have a flexural modulus from 4,000 MPa to 18,000 MPa when determined in accordance with ASTM D790 at a speed of 1.27 mm/min. In a still further embodiment, a molded article comprising the disclosed blended thermoplastic compositions can have a flexural modulus from 5,000 MPa to 16,000 MPa when determined in accordance with ASTM D790 at a speed of 1.27 mm/min.

In various embodiments, a molded article comprising the disclosed blended thermoplastic compositions can have a flexural stress at 5% strain from 0 MPa to 200 MPa when determined in accordance with ASTM D790 at a speed of 1.27 mm/min. In a further embodiment, a molded article comprising the disclosed blended thermoplastic compositions

can have a flexural stress at 5% from 0 MPa to 150 MPa when determined in accordance with ASTM D790 at a speed of 1.27 mm/min. In a still further embodiment, a molded article comprising the disclosed blended thermoplastic compositions can have a flexural stress at 5% from 0 MPa to 100 MPa when determined in accordance with ASTM D790 at a speed of 1.27 mm/min.

In various embodiments, a molded article comprising the disclosed blended thermoplastic compositions can have a flexural stress at yield from 20 MPa to 200 MPa when determined in accordance with ASTM D790 at a speed of 1.27 mm/min. In a further embodiment, a molded article comprising the disclosed blended thermoplastic compositions can have a flexural stress at yield from 50 MPa to 180 MPa when determined in accordance with ASTM D790 at a speed of 1.27 mm/min. In a still further embodiment, a molded article comprising the disclosed blended thermoplastic compositions can have a flexural stress at yield from 80 MPa to 140 MPa when determined in accordance with ASTM D790 at a speed of 1.27 mm/min.

In various embodiments, a molded article comprising the disclosed blended thermoplastic compositions can have a flexural stress at break from 20 MPa to 200 MPa when determined in accordance with ASTM D790 at a speed of 1.27 mm/min. In a further embodiment, a molded article comprising the disclosed blended thermoplastic compositions can have a flexural stress at break from 50 MPa to 180 MPa when determined in accordance with ASTM D790 at a speed of 1.27 mm/min. In a still further embodiment, a molded article comprising the disclosed blended thermoplastic compositions can have a flexural stress at break from 80 MPa to 140 MPa when determined in accordance with ASTM D790 at a speed of 1.27 mm/min.

In various embodiments, a molded article comprising the disclosed blended thermoplastic compositions can have a notched Izod impact strength from 10 joules per meter (J/m) to 50 J/m when determined in accordance with ASTM D256. In a further embodiment, a molded article comprising the disclosed blended thermoplastic compositions can have a notched Izod impact strength from 15 J/m to 45 J/m when determined in accordance with ASTM D256. In a still further embodiment, a molded article comprising the disclosed blended thermoplastic compositions can have a notched Izod impact strength from 20 J/m to 40 J/m when determined in accordance with ASTM D256.

In various embodiments, a molded article comprising the disclosed blended thermoplastic compositions can have an unnotched Izod impact strength from 100 J/m to 800 J/m when determined in accordance with ASTM D256. In a further embodiment, a molded article comprising the disclosed blended thermoplastic compositions can have an unnotched Izod impact strength from 200 J/m to 700 J/m when determined in accordance with ASTM D256. In a still further embodiment, a molded article comprising the disclosed blended thermoplastic compositions can have an unnotched Izod impact strength from 300 J/m to 600 J/m when determined in accordance with ASTM D256.

In various embodiments, a molded article comprising the disclosed blended thermoplastic compositions can have a heat deflection temperature from 100°C to 280°C when determined in accordance with ASTM D648. In a further embodiment, a molded article comprising the disclosed blended thermoplastic compositions can have a heat deflection temperature from 125°C to 270°C when determined in accordance with ASTM D648. In a still further embodiment, a molded article comprising the disclosed blended thermoplastic compositions can have a heat deflection temperature from 150°C to 260°C when determined in accordance with ASTM D648.

In various embodiments, the present disclosure pertains to and includes at least the following embodiments.

Embodiment 1. A blended thermoplastic composition comprising: a) from 50 wt% to 95 wt% of a first polyamide polymer and a second polyamide polymer; wherein the first polyamide polymer comprises polyamide 6 and polyamide 6,6; and wherein the second polyamide polymer is selected from polyamide 10,10; polyamide 10,12; or polyamide 12,12 or a combination thereof; b) from 4 wt% to 49.95 wt% of a thermally conductive filler wherein the thermally conductive filler is a high thermally conductive filler having a thermal conductivity greater than or equal to 50 W/mK, and comprises AlN, $Al_4C_3$, $Al_2O_3$, BN, AlON, $MgSiN_2$, SiC, $Si_3N_4$, graphite, expanded graphite, graphene, or carbon fiber, or combinations thereof; and c) from 0.05 wt% to 20 wt% of a laser direct structuring additive; wherein the combined weight percent value of all components does not exceed 100 wt%; wherein all weight percent values are based on the total weight of the composition; wherein a molded sample of the blended thermoplastic composition has a through plane thermal conductivity of at least 0.40 W/mK when determined in accordance with ASTM E1461 according to the description ; and wherein a molded sample of the blended thermoplastic composition exhibits a plating index value of at least 0.4 when determined in accordance with ASTM B568 according to the description.

Embodiment 2. The composition of Embodiment 1, wherein the polyamide polymer has a low viscosity.

Embodiment 3. The composition of any of Embodiments 1-2, wherein the high thermally conductive filler comprises AlN, $Al_2O_3$, BN, SiC, graphite, expanded graphite, or carbon fiber, or combinations thereof.

Embodiment 4. The composition of any of Embodiments 1-3, wherein the high thermally conductive filler comprises BN, graphite, or expanded graphite, or combinations thereof.

Embodiment 5. The composition of any of Embodiments 1-4, wherein the thermally conductive filler is present in an amount from 10 wt% to 40 wt%.

Embodiment 6. The composition of any of Embodiments 1-5, further comprising a thermally insulating filler.

Embodiment 7. The composition of Embodiment 6, wherein the thermally insulating filler has a conductivity of less than or equal to 10 W/mK.

Embodiment 8. The composition of Embodiment 6 or 7, wherein the thermally insulating filler comprises $Mg(OH)_2$, $CaCO_3$, mica, γ-AlO(OH), BaO, $BaSO_4$, AlO(OH), $CaSiO_3$, $ZrO_2$, $SiO_2$, glass beads, glass fiber, $H_2Mg_3(SiO_3)_4$, $AL(OH)_3$, $MgO \cdot xAl_2O_3$, $CaMg(CO_3)_2$, ceramic-coated graphite, or clay, or combinations thereof.

Embodiment 9. The composition of Embodiment 6 or 7, wherein the thermally insulating filler comprises $Mg(OH)_2$, $CaCO_3$, mica, γ-AlO(OH), $SiO_2$, glass beads, glass fiber, $H_2Mg_3(SiO_3)_4$, $Al(OH)_3$, or clay, or combinations thereof.

Embodiment 10. The composition of Embodiment 6 or 7, wherein the thermally insulating filler comprises $Mg(OH)_2$, glass fiber, $H_2Mg_3(SiO_3)_4$, or $Al(OH)_3$, or combinations thereof.

Embodiment 11. The composition of any of Embodiments 1-10, wherein the laser direct structuring additive is selected from a metal oxide or a metal oxide-coated filler, or a combination thereof.

Embodiment 12. The composition of Embodiment 11, wherein the laser direct structuring additive is a metal oxide comprising a copper-containing metal oxide, a titanium-containing metal oxide, a tin-containing metal oxide, a zinc-containing metal oxide, a magnesium-containing metal oxide, an aluminum-containing metal oxide, a gold-containing metal oxide, or a silver-containing metal oxide, or a combination thereof.

Embodiment 13. The composition of Embodiment 11, wherein the laser direct structuring additive is a metal-oxide coated filler comprising a mineral substrate and a coating comprising an antimony doped tin oxide, a copper-containing metal oxide, a zinc-containing metal oxide, a tin-containing metal oxide, a magnesium-containing metal oxide, an aluminum-containing metal oxide, a gold-containing metal oxide, or a silver-containing metal oxide, or a combination thereof.

Embodiment 14. The composition of Embodiment 11, wherein the laser direct structuring additive is a copper-containing material.

Embodiment 15. The composition of any of Embodiments 1-13, wherein the laser direct structure additive is copper hydroxide phosphate.

Embodiment 16. The composition of any of Embodiments 1-15, wherein the laser direct structuring additive is present in an amount from 0.5 wt% to 20 wt%.

Embodiment 17. The composition of any of Embodiments 1-15, wherein the laser direct structuring additive is present in an amount from 0.5 wt% to 10 wt%.

Embodiment 18. The composition of any of Embodiments 1-15, wherein the laser direct structuring additive is present in an amount from 0.5 wt% to 5 wt%.

Embodiment 19. The composition of any of Embodiments 1-15, wherein the laser direct structuring additive is present in an amount from 1 wt% to 5 wt%.

Embodiment 20. The composition of any of Embodiments 1-19, wherein a flame retardant is not present.

Embodiment 21. The composition of any of Embodiments 1-19, further comprising a flame retardant.

Embodiment 22. The composition of Embodiment 21, wherein the flame retardant is a phosphorous-containing flame retardant.

Embodiment 23. The composition of Embodiment 22, wherein the phosphorous-containing flame retardant comprises a phosphine, a phosphine oxide, a bisphosphine, a phosphonium salt, a phosphinic acid salt, a phosphoric ester, or a phosphorous ester, or a combination thereof.

Embodiment 24. The composition of Embodiments 22 and 23, wherein the phosphorous-containing flame retardant is oligomeric.

Embodiment 25. The composition of Embodiments 22-24, wherein the phosphorous-containing flame retardant comprises an aromatic polyphosphate oligomer, a phenoxyphosphazene oligomer, a melamine polyphosphate oligomer, or a metal phosphinate oligomer, or a combination thereof.

Embodiment 26. The composition of Embodiments 22-25, wherein the phosphorous-containing flame retardant comprises bisphenol-A bis(diphenyl phosphate), 1,3-phenylene tetraphenyl ester, bisphenol-A bis(diphenyl phosphate), red phosphorous, or Clariant Exolite OP series FR, or a combination thereof.

Embodiment 27. The composition of any of Embodiments 1-26 further comprising an additive comprising an antioxidant, a lubricant, a thermal stabilizer, an ultraviolet light absorbing additive, a plasticizer, an anti-dripping agent, a mold release agent, an antistatic agent, a dye, a pigment, or a radiation stabilizer, or a combination thereof.

Embodiment 28. The composition of any of Embodiments 1-27, wherein a molded sample of the blended thermoplastic composition has a through plane thermal conductivity of at least 0.45 W/mK when determined in accordance with ASTM E1461.

Embodiment 29. The composition of any of Embodiments 1-27, wherein a molded sample of the blended thermoplastic composition has a through plane thermal conductivity of at least 0.50 W/mK when determined in accordance with ASTM E1461.

Embodiment 30. The composition of any of Embodiments 1-27, wherein a molded sample of the blended thermoplastic composition has a through plane thermal conductivity from 0.40 W/mK to 25 W/mK when determined in

accordance with ASTM E1461.

Embodiment 31. The composition of any of Embodiments 1-27, wherein a molded sample of the blended thermoplastic composition has a through plane thermal conductivity from 0.45 W/mK to 23 W/mK when determined in accordance with ASTM E1461.

Embodiment 32. The composition of any of Embodiments 1-27, wherein a molded sample of the blended thermoplastic composition has a through plane thermal conductivity from 0.50 W/mK to 20 W/mK when determined in accordance with ASTM E1461.

Embodiment 33. The composition of any of Embodiments 1-32, wherein a molded sample of the blended thermoplastic composition exhibits a plating index value of at least 0.6.

Embodiment 34. The composition of any of Embodiments 1-32, wherein a molded sample of the blended thermoplastic composition exhibits a plating index value of at least 0.7.

Embodiment 35. The composition of any of Embodiments 1-32, wherein a molded sample of the blended thermoplastic composition exhibits a plating index value from 0.5 to 1.5.

Embodiment 36. The composition of any of Embodiments 1-32, wherein a molded sample of the blended thermoplastic composition exhibits a plating index value from 0.6 to 1.2.

Embodiment 37. The composition of any of Embodiments 1-32, wherein a molded sample of the blended thermoplastic composition exhibits a plating index value from 0.7 to 1.9.

Embodiment 38. An article comprising a composition of any of Embodiments 1-37.

Embodiment 39. The article of Embodiment 38, wherein the article is a molded article.

Embodiment 40. The article of Embodiment 39, wherein the molded article is extrusion molded.

Embodiment 41. The article of Embodiment 39, wherein the molded article is injection molded.

Embodiment 42. The article of any of Embodiments 38-41, wherein the article is selected from a computer device, electromagnetic interference device, printed circuit, Wi-Fi device, Bluetooth device, GPS device, cellular antenna device, smart phone device, automotive device, medical device, sensor device, security device, shielding device, RF antenna device, LED device and RFID device.

Embodiment 43. The article of any of Embodiments 38-41, wherein the article is selected from a computer device, electromagnetic interference device, automotive device, medical device, sensor device, security device, shielding device, RF antenna device, LED device and RFID device.

Embodiment 44. The article of any of Embodiments 38-41, wherein the article is selected from a computer device, sensor device, security device, RF antenna device, LED device and RFID device.

Embodiment 45. The article of any of Embodiments 38-41, wherein the article is selected from a computer device, LED device and RFID device.

Embodiment 46. The article of any of Embodiments 38-41, wherein the article is a LED device.

Embodiment 47. A method of improving thermal conductivity properties of a blended thermoplastic composition, the method comprising the step of combining: a) from 50 wt% to 95 wt% of a polyamide polymer, wherein the polyamide polymer comprises a first polyamide polymer and a second polyamide polymer; wherein the first polyamide polymer comprises polyamide 6 and polyamide 6,6; and wherein the second polyamide polymer is selected from polyamide 10,10; polyamide 10,12; or polyamide 12,12; or a combination thereof; b) from 4 wt% to 49.95 wt% of a thermally conductive filler, wherein the thermally conductive filler is a high thermally conductive filler having a thermal conductivity greater than or equal to 50 W/mK, and comprises AlN, $Al_4C_3$, $Al_2O_3$, BN, AlON, $MgSiN_2$, SiC, $Si_3N_4$, graphite, expanded graphite, graphene, or carbon fiber, or combinations thereof; and c) from 0.05 wt% to 20 wt% of a laser direct structuring additive; wherein the combined weight percent value of all components does not exceed 100 wt%; wherein all weight percent values are based on the total weight of the composition; wherein a molded sample of the blended thermoplastic composition has a through plane thermal conductivity of at least 0.40 W/mK when determined in accordance with ASTM E1461 according to the description; and wherein a molded sample of the blended thermoplastic composition exhibits a plating index value of at least 0.4 when determined in accordance with ATSM B568 according to the description.

## EXAMPLES

Unless indicated otherwise, parts are parts by weight, temperature is in °C or is at ambient temperature, and pressure is at or near atmospheric. Unless indicated otherwise, percentages referring to composition are in terms of wt%.

The materials shown in Table 1 were used to prepare the compositions described and evaluated herein. All samples were prepared by melt extrusion on a Toshiba Twin screw extruder, using different melt temperature and RPM according to different base resin. Tests were all conducted in accordance with ASTM standards, referenced in each test below.

The special gravity ("SG") was determined in accordance with ASTM D792.

Melt Volume-flow Rate (MVR) was determined in accordance with ASTM D1238 under a load of 5.0 kg and at

275°C.

Izod impact strength was determined at 23 °C on 3.2 mm thick injection molded samples in accordance with ASTM D256 (notched Izod impact strength, "NII"), and in accordance with ASTM D4812 (unnotched Izod impact strength, "UII").

Tensile testing was carried out at 5 mm/min at 23°C on standard tensile injection molded bars in accordance with ASTM D638.

Flexural testing was carried out at 2.54 mm/min and 3.2 mm thick injection molded sample in accordance with ASTM D790.

Heat deflection temperature ("HDT" was determined at 1.82 MPa on injection molded samples (3.2 mm x 12. 5 mm bars) in accordance with ASTM D648.

Plating index was determined in accordance with ASTM B568 by testing the copper thickness using X-Ray Fluorescence ("XRF"). Briefly, LDS is carried out on molded plaques with laser power, frequency, and speed varied as indicated. A reference sample for XRF determinations was prepared using Pocan™ DP 7102 with copper plating at 5 $\mu$m. Copper thickness was determined on the reference sample on both sides and at four discrete sample points. The copper thickness values were averaged for the reference sample and the average value is referred to $X_{ref}$. The plating index is defined by the following equation:

$$\text{Plating index} = \frac{\text{Average copper thickness for one parameter field}}{\text{Average copper thickness for reference sick } X_{ref}}$$

Thermal conductivity ("TC") was conducted in accordance with ASTM E1461 measured using a Nanoflash LFA 447 xenon flash apparatus (Netzsch Group). The reference standard was pyroceram of similar thickness. Measurements are provided in units of $\kappa$ (W/mK). The measurement determines the thermal diffusivity ($\alpha$, $cm^2/s$) and the specific heat (centipoise (Cp), joules per gram kelvin (J/gK)) of the sample, together with the density ($\rho$, grams per cubic centimeter ($g/cm^3$)). Density was determined using a water immersion method (ASTM D792). The product of three values ($\alpha$, $\rho$, and Cp) gives the thermal conductivity in the through plane according to the following equation:

$$\kappa = \alpha(T) \times Cp(T) \times \rho(T).$$

TABLE 1.

| Component | Chemical Description | Source |
|---|---|---|
| PA1 | Polyamide (PA66) resin | BASF Auxiliary Chemicals Co. Ltd |
| PA2 | Polyamide (10,10) resin | Suzhou Hipro Polymers Co., Ltd. |
| RA1 | N,N'-1,2-ethanediylbis-Octadecanamide (80~98wt%), Stearic acid (<3%), Acrawax C beads | Lonza Group Ltd. |
| TS1 | Tris(2,4-ditert-butylphenyl) phosphite, stabilizer | Ciba Specialty Chemicals |
| TS2 | N,N'-Hexane-1,6-diylbis[3-(3,5-di-tert-butyl-4-hydroxyphenylpropionamide], anti-oxidant | Ciba Central Eastern Europe Kft |
| CB1 | Pigment carbon black, powder | Cabot Specialty Chemicals Inc. |
| MD1 | 2,2'-oxalyldiamidobis[ethyl 3-(3,5-di-tert-butyl-4-hydroxyphenyl) propionate], Metal deactivator | Chemtura Europe Limited |
| M1 | copper hydroxide phosphate | Sinopharm Chemical Reagent Co., Ltd. |
| MS1 | Benzenepropanoic acid, 3,5-bis(1,1-dimethylethyl)-4-hydroxy-, 2-[3-[3,5-bis(1,1-dimethylethyl)-4-hydroxyphenyl]-1-oxopropyl] hydrazide, copper stabilizer | BASF Performance Products Trading (Shanghai) Limited |
| F1 | Hexagonal boron nitride | Dandong Chemical Engineering Institute Co., Ltd. |
| F2 | Aminosilane-treated magnesium hydroxide | Martinswerk GmbH |

(continued)

| Component | Chemical Description | Source |
|---|---|---|
| F3 | Asbury graphite | Asbury Graphite Mills, Inc. |

The materials used in preparing the samples are listed in Table 1 and were prepared using a Twin screw extruder (Toshiba TEM-37BS, L/D=40.5) with the temperature of the extruder barrel set at 260 °C. Pellets extruded from the extruder were then injection molded into 80×10×3 mm bar, cut into 10×10×3 mm square sample for through plane thermal conductivity measurement, Φ100×0.4 mm sheet and cut into Φ25×0.4 mm round sample for in plane thermal conductivity measurement.

Exemplary formulations #1-7 are shown in Table 2, using the materials shown in Table 1. All materials are provided in wt% wherein all weight percent values are based on the total weight of the given formulation. The compounding profile for the preparation of the various formulations shown in Table 2 is given in Table 3, while the molding profile used to prepare molded samples from the formulations is given in Table 4. Molded samples were prepared using these formulations and characterized by various tests described herein above, with the results shown in Table 5. The examples 4 and 5 in Table 2 are comparative examples.

TABLE 2.

| Component | 1 | 2 | 3 | 4 | 5 | 6 | 7 |
|---|---|---|---|---|---|---|---|
| PA1 | 85.9 | 58.9 | 55.9 | 58.9 | 55.9 | 58.9 | 55.9 |
| PA2 | 10 | 10 | 10 | 10 | 10 | 10 | 10 |
| RA1 | 0.2 | 0.2 | 0.2 | 0.2 | 0.2 | 0.2 | 0.2 |
| TS1 | 0.15 | 0.15 | 0.15 | 0.15 | 0.15 | 0.15 | 0.15 |
| TS2 | 0.2 | 0.2 | 0.2 | 0.2 | 0.2 | 0.2 | 0.2 |
| CB1 | 0.3 | 0.3 | 0.3 | 0.3 | 0.3 | 0.3 | 0.3 |
| MD1 | 0.2 | 0.2 | 0.2 | 0.2 | 0.2 | 0.2 | 0.2 |
| M1 | 3 | | 3 | | 3 | | 3 |
| MS1 | 0.1 | 0.1 | 0.1 | 0.1 | 0.1 | 0.1 | 0.1 |
| F1 | | 30 | 30 | | | | |
| F2 | | | | 30 | 30 | | |
| F3 | | | | | | 30 | 30 |
| Formulation Total | 100 | 100 | 100 | 100 | 100 | 100 | 100 |

TABLE 3.

| Parameters | UOM* | Value |
|---|---|---|
| Compounder Type | None | Toshiba TEM-37BS |
| Barrel Size | mm | 1500 |
| Die | mm | 3 |
| Zone 1 Temp | °C | 100 |
| Zone 2 Temp | °C | 150 |
| Zone 3 Temp | °C | 200 |
| Zone 4 Temp | °C | 255 |
| Zone 5 Temp | °C | 255 |
| Zone 6 Temp | °C | 255 |
| Zone 7 Temp | °C | 255 |

(continued)

| Parameters | UOM* | Value |
|---|---|---|
| Compounder Type | None | Toshiba TEM-37BS |
| Zone 8 Temp | °C | 255 |
| Zone 9 Temp | °C | 255 |
| Zone 10 Temp | °C | 255 |
| Zone 11 Temp | °C | 255 |
| Die Temp | °C | 260 |
| Screw speed | rpm | 350 |
| Throughput | kg/hr | 50 |
| Vacuum | MPa | -0.08 |
| Side Feeder speed | Rpm | 300 |
| Side feeder 1 | Note | barrel 7 |
| *Unit of measure ("UOM") | | |

TABLE 4.

| Parameter | Unit | Value |
|---|---|---|
| Pre-drying time | Hour | 4 |
| Pre-drying temperature | °C | 85 |
| Hopper temp | °C | 50 |
| Zone 1 temp | °C | 275 |
| Zone 2 temp | °C | 280 |
| Zone 3 temp | °C | 280 |
| Nozzle temp | °C | 280 |
| Mold temp | °C | 90 |
| Screw speed | rpm | 80 |
| Back pressure | $kgf/cm^2$ | 30 |
| Cooling time | s | 15 |
| Injection speed | mm/s | 60 |
| Holding pressure | $kgf/cm^2$ | 800 |
| Max. Injection pressure | $kgf/cm^2$ | 1000 |

The effect of LDS additives and different kinds of thermally conductive fillers on the mechanical properties and plating performance of PA66 base resin is shown in Table 5. In the thermal conductivity test, pellets from the extruder were then injection molded into a 80x10x3 mm bar and cut into 10x10x3 mm square sample for through plane thermal conductivity measurement.

The performance comparison of different kinds of thermally conductive fillers including graphite, magnesium hydroxide and BN with/without 3% LDS additive in PA composites is also given in Table 5. As can be seen, all the samples with 3% LDS additive (Formulations #3, #5 and #7) have similar mechanical properties and thermal conductivity when compared to samples without LDS additive (Formulations #2, #4 and 6#), indicating that these materials can be used as thermally conductive plastics composites. For plating index, Formulation #3 with the addition of 30% BN has higher PI values when compared with samples with 30% magnesium hydroxide and graphite as compared to control samples without thermally conductive fillers. Importantly, the addition of BN and magnesium hydroxide have synergistic

effects with the LDS additive on plating performance of composites, as verified by plating index. As such, the addition of an LDS additive yields successful laser direct structuring.

In summary, by adding a LDS additive to thermally conductive polymer compositions, the compositions are thermally conductive materials which provide solutions to a variety of electrical, electronic and thermal design problems throughout industry, which can undergo laser structuring and chemical plating to etch circuit patterns on molded polymer components and metalize the circuits in the areas activated by the laser.

TABLE 5.

| Test Description | Unit | #1 | #2 | #3 | #4 | #5 |
|---|---|---|---|---|---|---|
| MVR-Avg (275°C/5kg) | $cm^3$/10 min | 197 | 73.8 | 194 | 89.6 | 99.5 |
| Modulus of Elasticity - Avg | MPa | 3321 | 6468 | 6856 | 4725 | 4792 |
| Stress at Break - Avg | MPa | 70.2 | 55.4 | 53.6 | 73.1 | 71.4 |
| Elongation at Break - Avg | % | 3.1 | 2.7 | 2.3 | 2.9 | 2.9 |
| Flexural Modulus - Avg | MPa | 2390 | 6080 | 6500 | 3570 | 3730 |
| Flex Stress @ 5% Strain - Avg | MPa | 99.1 | 0 | 0 | 92.9 | 93.6 |
| Flexural Stress @ Yield – Avg | MPa | 104 | 101 | 93.6 | 118 | 118 |
| Flexural Stress @ Break - Avg | MPa | 103 | 101 | 93.4 | 118 | 118 |
| Impact Strength – Avg (notched) | J/m | 30.5 | 29.8 | 20.1 | 33.4 | 30.7 |
| Impact Strength – Avg (unnotched) | J/m | 223 | 293 | 278 | 602 | 587 |
| Deflection temp – Avg | °C | 74.4 | 155 | 166 | 85.2 | 91.5 |

| Test Description | Unit | #1 | #2 | #3 | #4 | #5 |
|---|---|---|---|---|---|---|
| Density - Avg | --- | 1.158 | 1.318 | 1.354 | 1.323 | 1.360 |
| Thermal conductivity | W/(m·K) | 0.45 | 1.1 | 1.2 | 0.65 | 0.65 |
| Plating index | --- | 0.63 | - | 0.83 | - | 0.69 |

TABLE 5 (CONTINUED).

| Test Description | Unit | #6 | #7 |
|---|---|---|---|
| MVR-Avg (275C/5kg) | $cm^3$/10 min | 66.1 | 50.2 |
| Modulus of Elasticity - Avg | MPa | 6314 | 6385 |
| Stress at Break - Avg | MPa | 56.9 | 54.6 |
| Elongation at Break - Avg | % | 2 | 1.9 |
| Flexural Modulus - Avg | MPa | 6020 | 6210 |
| Flex Stress @ 5% Strain - Avg | MPa | 0 | 0 |
| Flexural Stress @ Yield – Avg | MPa | 91.5 | 91.3 |
| Flexural Stress @ Break - Avg | MPa | 91.3 | 91.2 |
| Impact Strength – Avg (notched) | J/m | 25.9 | 22.4 |
| Impact Strength – Avg (unnotched) | J/m | 208 | 158 |
| Deflection temp – Avg | °C | 171 | 169 |
| Density - Avg | --- | 1.328 | 1.359 |
| Thermal conductivity | W/(m·K) | 1.3 | 1.4 |
| Plating index | --- | - | 0.49 |

## Claims

**1.** A blended thermoplastic composition comprising:

a. from 50 wt% to 95 wt% of a polyamide polymer, wherein the polyamide polymer comprises a first polyamide polymer and a second polyamide polymer; wherein the first polyamide polymer comprises polyamide 6 and polyamide 6,6; and wherein the second polyamide polymer is selected from polyamide 10,10; polyamide 10,12; or polyamide 12,12; or a combination thereof;
b. from 4 wt% to 49.95 wt% of a thermally conductive filler, wherein the thermally conductive filler is a high thermally conductive filler having a thermal conductivity greater than or equal to 50 W/mK, and comprises AlN, $Al_4C_3$, $Al_2O_3$, BN, AlON, $MgSiN_2$, SiC, $Si_3N_4$, graphite, expanded graphite, graphene, or carbon fiber, or combinations thereof; and
c. from 0.05 wt% to 20 wt% of a laser direct structuring additive;

wherein the combined weight percent value of all components does not exceed 100 wt%;
wherein all weight percent values are based on the total weight of the composition;
wherein a molded sample of the blended thermoplastic composition has a through plane thermal conductivity of at least 0.40 W/mK when determined in accordance with ASTM E1461 according to the description ; and
wherein a molded sample of the blended thermoplastic composition exhibits a plating index value of at least 0.4

when determined in accordance with ATSM B568 according to the description.

2. The blended thermoplastic composition of claim 1, wherein the high thermally conductive filler comprises BN, graphite, or expanded graphite, or combinations thereof.

3. The blended thermoplastic composition of any of claim 1-2, further comprising a thermally insulating filler having a conductivity of less than or equal to 10 W/mK.

4. The blended thermoplastic composition of claim 3, wherein the thermally insulating filler comprises $Mg(OH)_2$, $CaCO_3$, mica, γ-AlO(OH), BaO, $BaSO_4$, AlO(OH), $CaSiO_3$, $ZrO_2$, $SiO_2$, glass beads, glass fiber, $H_2Mg_3(SiO_3)_4$, $AL(OH)_3$, $MgO•xAl_2O_3$, $CaMg(CO_3)_2$, ceramic-coated graphite, or clay, or combinations thereof.

5. The blended thermoplastic composition of any of claims 1-4, wherein the laser direct structuring additive comprises a metal oxide or a metal oxide-coated filler, or a combination thereof.

6. The blended thermoplastic composition of any of claims 1-5, wherein the laser direct structuring additive is a metal oxide comprising a copper-containing metal oxide, a titanium-containing metal oxide, a tin-containing metal oxide, a zinc-containing metal oxide, a magnesium-containing metal oxide, an aluminum-containing metal oxide, a gold-containing metal oxide, or a silver-containing metal oxide, or a combination thereof, or wherein the laser direct structuring additive is a metal-oxide coated filler comprising a mineral substrate and a coating comprising an antimony doped tin oxide, a copper-containing metal oxide, a zinc-containing metal oxide, a tin-containing metal oxide, a magnesium-containing metal oxide, an aluminum-containing metal oxide, a gold-containing metal oxide, or a silver-containing metal oxide, or a combination thereof.

7. The blended thermoplastic composition of any of claims 1-6, wherein the laser direct structuring additive is present in an amount from 0.5 wt% to 5 wt%.

8. The blended thermoplastic composition of any of claims 1-7, further comprising a flame retardant, wherein the flame retardant is a phosphorous-containing flame retardant comprising a phosphine, a phosphine oxide, a bisphosphine, a phosphonium salt, a phosphinic acid salt, a phosphoric ester, or a phosphorous ester, or a combination thereof.

9. The blended thermoplastic composition of any of claims 1-8, further comprising an additive comprising an antioxidant, a lubricant, a thermal stabilizer, an ultraviolet light absorbing additive, a plasticizer, an anti-dripping agent, a mold release agent, an antistatic agent, a dye, a pigment, or a radiation stabilizer, or a combination thereof.

10. An article comprising a composition of any of claims 1-9.

11. The article of claim 10, wherein the article is selected from a computer device, electromagnetic interference device, printed circuit, Wi-Fi device, Bluetooth device, GPS device, cellular antenna device, smart phone device, automotive device, medical device, sensor device, security device, shielding device, RF antenna device, LED device and RFID device.

12. A method of improving thermal conductivity properties of a blended thermoplastic composition, the method comprising the step of combining:

a. from 50 wt% to 95 wt% of a polyamide polymer, wherein the polyamide polymer comprises a first polyamide polymer and a second polyamide polymer; wherein the first polyamide polymer comprises polyamide 6 and polyamide 6,6; and wherein the second polyamide polymer is selected from polyamide 10,10; polyamide 10,12; or polyamide 12,12; or a combination thereof;
b. from 4 wt% to 49.95 wt% of a thermally conductive filler, wherein the thermally conductive filler is a high thermally conductive filler having a thermal conductivity greater than or equal to 50 W/mK and comprises AlN, $Al_4C_3$, $Al_2O_3$, BN, AlON, $MgSiN_2$, SiC, $Si_3N_4$, graphite, expanded graphite, graphene, or carbon fiber, or combinations thereof; and
c. from 0.05 wt% to 20 wt% of a laser direct structuring additive;

wherein the combined weight percent value of all components does not exceed 100 wt%;
wherein all weight percent values are based on the total weight of the composition;
wherein a molded sample of the blended thermoplastic composition has a through plane thermal conductivity of at

least 0.40 W/mK when determined in accordance with ASTM E1461 according to the description ; and
wherein a molded sample of the blended thermoplastic composition exhibits a plating index value of at least 0.4 when determined in accordance with ATSM B568 according to the description.

## Patentansprüche

1. Vermischte thermoplastische Zusammensetzung, umfassend:

   a. zu 50 Gew.-% bis 95 Gew.-% ein Polyamidpolymer, wobei das Polyamidpolymer ein erstes Polyamidpolymer und ein zweites Polyamidpolymer umfasst; wobei das erste Polyamidpolymer Polyamid 6 und Polyamid 6,6 umfasst; und wobei das zweite Polyamidpolymer ausgewählt ist aus Polyamid 10,10; Polyamid 10,12; oder Polyamid 12,12; oder einer Kombination davon;
   b. zu 4 Gew.-% bis 49,95 Gew.-% ein wärmeleitfähiges Füllmittel, wobei das wärmeleitfähige Füllmittel ein hochwärmeleitfähiges Füllmittel mit einer Wärmeleitfähigkeit größer als oder gleich 50 W/mK ist und AlN, $Al_4C_3$, $Al_2O_3$, BN, AlON, $MgSiN_2$, SiC, $Si_3N_4$, Graphit, expandiertes Graphit, Graphen oder Kohlenstofffaser oder Kombinationen davon umfasst; und
   c. zu 0,05 Gew.-% bis 20 Gew.-% einen Laserdirektstrukturierungszusatzstoff;

   wobei der kombinierte Gewichtsprozentwert aller Bestandteile 100 Gew.-% nicht überschreitet;
   wobei alle Gewichtsprozentwerte auf das Gesamtgewicht der Zusammensetzung bezogen sind;
   wobei eine geformte Probe der vermischten thermoplastischen Zusammensetzung eine Wärmeleitfähigkeit durch die Ebene von mindestens 0,40 W/mK aufweist, wenn in Übereinstimmung mit ASTM E1461 gemäß der Beschreibung bestimmt; und
   wobei eine geformte Probe der vermischten thermoplastischen Zusammensetzung einen Plattierungsindexwert von mindestens 0,4 vorweist, wenn in Übereinstimmung mit ASTM B568 gemäß der Beschreibung bestimmt.

2. Vermischte thermoplastische Zusammensetzung nach Anspruch 1, wobei das hochwärmeleitfähige Füllmittel BN, Graphit oder expandiertes Graphit oder Kombinationen davon umfasst.

3. Vermischte thermoplastische Zusammensetzung nach einem von Anspruch 1-2, ferner umfassend ein thermisch isolierendes Füllmittel mit einer Leitfähigkeit von weniger als oder gleich 10 W/mK.

4. Vermischte thermoplastische Zusammensetzung nach Anspruch 3, wobei das thermisch isolierende Füllmittel $Mg(OH)_2$, $CaCO_3$, Glimmer, y-AlO(OH), BaO, $BaSO_4$, AlO(OH), $CaSiO_3$, $ZrO_2$, $SiO_2$, Glaskügelchen, Glasfaser, $H_2Mg_3(SiO_3)_4$, $AL(OH)_3$, $MgO \cdot xAl_2O_3$, $CaMg(CO_3)_2$, keramikbeschichtetes Graphit oder Tonerde oder Kombinationen davon umfasst.

5. Vermischte thermoplastische Zusammensetzung nach einem der Ansprüche 1-4, wobei der Laserdirektstrukturierungszusatzstoff ein Metalloxid oder ein metalloxidbeschichtetes Füllmittel oder eine Kombination davon umfasst.

6. Vermischte thermoplastische Zusammensetzung nach einem der Ansprüche 1-5, wobei der Laserdirektstrukturierungszusatzstoff ein Metalloxid ist, umfassend ein kupferhaltiges Metalloxid, ein titanhaltiges Metalloxid, ein zinnhaltiges Metalloxid, ein zinkhaltiges Metalloxid, ein magnesiumhaltiges Metalloxid, ein aluminiumhaltiges Metalloxid, ein goldhaltiges Metalloxid, oder ein silberhaltiges Metalloxid oder eine Kombination davon umfasst, oder wobei der Laserdirektstrukturierungszusatzstoff ein metalloxidbeschichtetes Füllmittel ist, umfassend ein Mineralsubstrat und eine Beschichtung, umfassend ein antimondotiertes Zinnoxid, ein kupferhaltiges Metalloxid, ein zinkhaltiges Metalloxid, ein zinnhaltiges Metalloxid, ein magnesiumhaltiges Metalloxid, ein aluminiumhaltiges Metalloxid, ein goldhaltiges Metalloxid oder ein silberhaltiges Metalloxid oder eine Kombination davon.

7. Vermischte thermoplastische Zusammensetzung nach einem der Ansprüche 1-6, wobei der Laserdirektstrukturierungszusatzstoff in einer Menge von 0,5 Gew.-% bis 5 Gew.-% vorhanden ist.

8. Vermischte thermoplastische Zusammensetzung nach einem der Ansprüche 1-7, ferner umfassend ein Flammschutzmittel, wobei das Flammschutzmittel ein phosphorhaltiges Flammschutzmittel ist, umfassend ein Phosphin, ein Phosphinoxid, ein Bisphosphin, ein Phosphoniumsalz, ein Phosphinsäuresalz, einen Phosphorsäureester oder einen Phosphorigsäureester oder eine Kombination davon.

9. Vermischte thermoplastische Zusammensetzung nach einem der Ansprüche 1-8, ferner umfassend einen Zusatzstoff, umfassend ein Antioxidationsmittel, ein Schmiermittel, einen Wärmestabilisator, einen ultraviolettes Licht absorbierenden Zusatzstoff, einen Weichmacher, ein Antitropfmittel, ein Formtrennmittel, ein Antistatikmittel, einen Farbstoff, ein Pigment oder einen Strahlungsstabilisator oder eine Kombination davon.

10. Artikel, umfassend eine Zusammensetzung nach einem der Ansprüche 1-9.

11. Artikel nach Anspruch 10, wobei der Artikel ausgewählt ist aus einer Computervorrichtung, elektromagnetischen Interferenzvorrichtung, Leiterplatte, Wi-Fi-Vorrichtung, Bluetooth-Vorrichtung, GPS-Vorrichtung, Funkantennenvorrichtung, Smartphonevorrichtung, selbstfahrenden Vorrichtung, medizinischen Vorrichtung, Sensorvorrichtung, Sicherheitsvorrichtung, Abschirmungsvorrichtung, HF-Antennenvorrichtung, LED-Vorrichtung und RFID-Vorrichtung.

12. Verfahren zum Verbessern von Wärmeleitfähigkeitseigenschaften einer vermischten thermoplastischen Zusammensetzung, wobei das Verfahren den Schritt des Kombinierens von Folgendem umfasst:

a. zu 50 Gew.-% bis 95 Gew.-% ein Polyamidpolymer, wobei das Polyamidpolymer ein erstes Polyamidpolymer und ein zweites Polyamidpolymer umfasst; wobei das erste Polyamidpolymer Polyamid 6 und Polyamid 6,6 umfasst; und wobei das zweite Polyamidpolymer ausgewählt ist aus Polyamid 10,10; Polyamid 10,12; oder Polyamid 12,12; oder einer Kombination davon;
b. zu 4 Gew.-% bis 49,95 Gew.-% ein wärmeleitfähiges Füllmittel, wobei das wärmeleitfähige Füllmittel ein hochwärmeleitfähiges Füllmittel mit einer Wärmeleitfähigkeit größer als oder gleich 50 W/mK ist und AlN, $Al_4C_3$, $Al_2O_3$, BN, AlON, $MgSiN_2$, SiC, $Si_3N_4$, Graphit, expandiertes Graphit, Graphen oder Kohlenstofffaser oder Kombinationen davon umfasst; und
c. zu 0,05 Gew.-% bis 20 Gew.-% einen Laserdirektstrukturierungszusatzstoff;

wobei der kombinierte Gewichtsprozentwert aller Bestandteile 100 Gew.-% nicht überschreitet;
wobei alle Gewichtsprozentwerte auf das Gesamtgewicht der Zusammensetzung bezogen sind;
wobei eine geformte Probe der vermischten thermoplastischen Zusammensetzung eine Wärmeleitfähigkeit durch die Ebene von mindestens 0,40 W/mK aufweist, wenn in Übereinstimmung mit ASTM E1461 gemäß der Beschreibung bestimmt; und
wobei eine geformte Probe der vermischten thermoplastischen Zusammensetzung einen Plattierungsindexwert von mindestens 0,4 vorweist, wenn in Übereinstimmung mit ASTM B568 gemäß der Beschreibung bestimmt.

## Revendications

1. Composition thermoplastique mélangée comprenant :

a. 50% en poids à 95% en poids d'un polymère polyamide, où le polymère polyamide comprend un premier polymère polyamide et un deuxième polymère polyamide ; où le premier polymère polyamide comprend le polyamide 6 et le polyamide 6,6 ; et où le deuxième polymère polyamide est choisi parmi le polyamide 10,10 ; le polyamide 10,12 ; ou le polyamide 12,12 ; ou une combinaison de ceux-ci ;
b. 4% en poids à 49,95% en poids d'une charge thermoconductrice, où la charge thermoconductrice est une charge hautement thermoconductrice ayant une conductivité thermique supérieure ou égale à 50 W/mK et comprend AlN, $Al_4C_3$, $Al_2O_3$, BN, AlON, $MgSiN_2$, SiC, $Si_3N_4$, du graphite, du graphite expansé, du graphène ou une fibre de carbone, ou des combinaisons de ceux-ci ; et
c. 0,05% en poids à 20% en poids d'un additif de structuration directe par laser ;

dans laquelle la valeur combinée en pourcentage en poids de tous les composants ne dépasse pas 100% en poids ;
dans laquelle toutes les valeurs en pourcentage en poids sont basées sur le poids total de la composition ;
dans laquelle un échantillon moulé de la composition thermoplastique mélangée a une conductivité thermique à travers le plan d'au moins 0,40 W/mK telle que déterminée conformément à la norme ASTM E1461 selon la description ; et
dans laquelle un échantillon moulé de la composition thermoplastique mélangée présente une valeur d'indice de placage d'au moins 0,4 telle que déterminée conformément à la norme ATSM B568 selon la description.

2. Composition thermoplastique mélangée de la revendication 1, dans laquelle la charge hautement thermoconductrice comprend BN, du graphite ou du graphite expansé, ou des combinaisons de ceux-ci.

3. Composition thermoplastique mélangée de l'une des revendications 1 et 2, comprenant en outre une charge thermiquement isolante ayant une conductivité inférieure ou égale à 10 W/mK.

4. Composition thermoplastique mélangée de la revendication 3, dans laquelle la charge thermiquement isolante comprend $Mg(OH)_2$, $CaCO_3$, du mica, γ-AlO(OH), BaO, $BaSO_4$, AlO(OH), $CaSiO_3$, $ZrO_2$, $SiO_2$, des perles de verre, une fibre de verre, $H_2Mg_3(SiO_3)_4$, $AL(OH)_3$, $MgO{\bullet}xAl_2O_3$, $CaMg(CO_3)_2$, du graphite revêtu de céramique, ou d'argile, ou des combinaisons de ceux-ci.

5. Composition thermoplastique mélangée de l'une des revendications 1 à 4, dans laquelle l'additif de structuration directe par laser comprend un oxyde métallique ou une charge revêtue d'oxyde métallique, ou une combinaison de ceux-ci.

6. Composition thermoplastique mélangée de l'une des revendications 1 à 5, dans laquelle l'additif de structuration directe par laser est un oxyde métallique comprenant un oxyde métallique contenant du cuivre, un oxyde métallique contenant du titane, un oxyde métallique contenant de l'étain, un oxyde métallique contenant du zinc, un oxyde métallique contenant du magnésium, un oxyde métallique contenant de l'aluminium, un oxyde métallique contenant de l'or ou un oxyde métallique contenant de l'argent, ou une combinaison de ceux-ci, ou dans laquelle l'additif de structuration directe par laser est une charge revêtue d'oxyde métallique comprenant un substrat minéral et un revêtement comprenant un oxyde d'étain dopé avec l'antimoine, un oxyde métallique contenant du cuivre, un oxyde métallique contenant du zinc, un oxyde métallique contenant de l'étain, un oxyde métallique contenant du magnésium, un oxyde métallique contenant de l'aluminium, un oxyde métallique contenant de l'or, ou un oxyde métallique contenant de l'argent, ou une combinaison de ceux-ci.

7. Composition thermoplastique mélangée de l'une des revendications 1 à 6, dans laquelle l'additif de structuration directe par laser est présent en une quantité comprise entre 0,5% en poids et 5% en poids.

8. Composition thermoplastique mélangée de l'une des revendications 1 à 7, comprenant en outre un agent ignifuge, dans laquelle l'agent ignifuge est un agent ignifuge contenant du phosphore comprenant une phosphine, un oxyde de phosphine, une bisphosphine, un sel de phosphonium, un sel d'acide phosphinique, un ester phosphorique, ou un ester phosphoreux, ou une combinaison de ceux-ci.

9. Composition thermoplastique mélangée de l'une des revendications 1 à 8, comprenant en outre un additif comprenant un antioxydant, un lubrifiant, un stabilisant thermique, un additif absorbant la lumière ultraviolette, un plastifiant, un agent anti-égouttement, un agent de démoulage, un agent antistatique, un colorant, un pigment ou un stabilisant de rayonnements, ou une combinaison de ceux-ci.

10. Article comprenant une composition de l'une des revendications 1 à 9.

11. Article de la revendication 10, dans lequel l'article est sélectionné parmi un dispositif informatique, un dispositif d'interférence électromagnétique, un circuit imprimé, un dispositif Wi-Fi, un dispositif Bluetooth, un dispositif GPS, un dispositif d'antenne cellulaire, un dispositif de téléphone intelligent, un dispositif automobile, un dispositif médical, un dispositif de détection, un dispositif de sécurité, un dispositif de protection, un dispositif d'antenne RF, un dispositif à LED et un dispositif RFID.

12. Procédé d'amélioration de propriétés de conductivité thermique d'une composition thermoplastique mélangée, le procédé comprenant l'étape consistant à combiner :

a. 50% en poids à 95% en poids d'un polymère polyamide, où le polymère polyamide comprend un premier polymère polyamide et un deuxième polymère polyamide ; où le premier polymère polyamide comprend le polyamide 6 et le polyamide 6,6 ; et où le deuxième polymère polyamide est choisi parmi le polyamide 10,10 ; le polyamide 10,12 ; ou le polyamide 12,12 ; ou une combinaison de ceux-ci ;
b. 4% en poids à 49,95% en poids d'une charge thermoconductrice, où la charge thermoconductrice est une charge hautement thermoconductrice ayant une conductivité thermique supérieure ou égale à 50 W/mK et comprend AlN, $Al_4C_3$, $Al_2O_3$, BN, AlON, $MgSiN_2$, SiC, $Si_3N_4$, du graphite, du graphite expansé, du graphène ou une fibre de carbone, ou des combinaisons de ceux-ci ; et
c. 0,05% en poids à 20% en poids d'un additif de structuration directe par laser ;

dans lequel la valeur combinée en pourcentage en poids de tous les composants ne dépasse pas 100% en poids ;

dans lequel toutes les valeurs en pourcentage en poids sont basées sur le poids total de la composition ;
dans lequel un échantillon moulé de la composition thermoplastique mélangée a une conductivité thermique à travers le plan d'au moins 0,40 W/mK telle que déterminée conformément à la norme ASTM E1461 selon la description ; et
dans lequel un échantillon moulé de la composition thermoplastique mélangée présente une valeur d'indice de placage d'au moins 0,4 telle que déterminée conformément à la norme ATSM B568 selon la description.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4970272 A, Gallucci
- US 2071250 A
- US 2071251 A
- US 2130523 A
- US 2130948 A, Carothers
- US 2241322 A
- US 2312966 A, Hanford
- US 2512606 A, Bolton